# EUROPEAN PATENT APPLICATION

(11) **EP 4 642 207 A1**
(43) Date of publication of application: **29.10.2025**
(21) Application number: 25152722.2
(22) Date of filing: 20.01.2025
(51) Int. Cl.: H10K 59/80, H10K 71/00

(54) **DISPLAY DEVICE**

(30) Priority: 22.04.2024 KR 20240053528
(71) Applicant: Samsung Display Co., Ltd., Yongin-si, Gyeonggi-do 17113 (KR)
(72) Inventor: Gong, Sucheol, Giheung-Gu, Yongin-si, Gyeonggi-Do (KR); Kim, Deukjong, Giheung-Gu, Yongin-si, Gyeonggi-Do (KR); Bae, Kichul, Giheung-Gu, Yongin-si, Gyeonggi-Do (KR); Lee, Dong-Cheol, Giheung-Gu, Yongin-si, Gyeonggi-Do (KR); Kang, Seulwoo, Giheung-Gu, Yongin-si, Gyeonggi-Do (KR)
(74) Representative: Dr. Weitzel & Partner

(57) **Abstract**

Disclosed is a display device including a display panel, a first conductive pattern above the display panel, a second conductive pattern above the first conductive pattern, an insulating layer above the second conductive pattern, and a cover layer above the insulating layer, wherein an edge of the insulating layer and an edge of the cover layer are aligned and are spaced from an edge of the display panel.

## Description

### BACKGROUND

### 1. Field

The present invention relates to a display device.

### 2. Description of the Related Art

In general, electronic devices, such as smartphones, digital cameras, laptop computers, navigation systems, and smart televisions, which provide images to users, include display devices for displaying images. The display device generates an image and provides the generated image to the user through a display screen. A display device includes a display panel that displays an image, and an input-sensing part that is located on the display panel to sense an external input.

Display devices may be vulnerable to external impacts. When a display device falls to a floor, an impact may be applied to a side surface of the display device, and thus, the side surface of the display device may be damaged. For example, side surfaces of some components of the input-sensing part may be delaminated from each other. Technology development is required to reduce or prevent damage to the side surface of the display device.

### SUMMARY

Embodiments of the present invention provide a display panel for reducing or preventing damage to a side surface of a display device. The invention is defined by the features of claim 1. The dependent claims describe preferred embodiments.

According to one or more embodiments, a display device includes a display panel, a first conductive pattern above the display panel, a second conductive pattern above the first conductive pattern, an insulating layer above the second conductive pattern, and a cover layer above the insulating layer, wherein an edge of the insulating layer and an edge of the cover layer are aligned, and are spaced from an edge of the display panel.

When used herein, the term "above" is used to describe embodiments with a first layer, pattern or structure which is defined above a second layer, pattern or structure is directly on the second layer, pattern or structure, and includes other embodiments in which the first layer, pattern or structure is disposed on the second layer, pattern or structure with one or more intermediate layers therebetween.

The display device may further include an adhesion layer above the cover layer and the display panel to cover the edge of the insulating layer and the edge of the cover layer, and a reflection reduction layer above the adhesion layer.

The display panel may include a substrate, and a pixel above the substrate, and wherein the adhesion layer directly contacts an upper surface of the substrate adjacent to an edge of the substrate.

A stepped portion may be defined by upper sides, left sides, and right sides of the display panel and of the insulating layer.

The display device may further include a dummy insulating layer above the display panel, and between the insulating layer and the edge of the display panel in plan view, wherein a groove is defined between the dummy insulating layer and the insulating layer.

A dummy insulating layer may be a layer which does not cover or at least does not directly cover a conductive element or structure of the display device. The groove may also be termed as a dummy insulating layer separating groove.

The dummy insulating layer and the insulating layer may include a same material.

The stepped portion and the groove may have a closed loop and may surround a display area of the display panel in a plan view.

The display device may further include a first dam layer above the display panel, and between the edge of the display panel and the insulating layer in a plan view, wherein a first groove is defined between the first dam layer and the insulating layer.

The display device may further include a first dam layer above the display panel, and between the edge of the display panel and the insulating layer in a plan view, and a second dam layer above the display panel, and between the edge of the display panel and the first dam layer in a plan view, wherein a first groove is defined between the first dam layer and the insulating layer, and wherein a second groove is defined between the second dam layer and the first dam layer.

The insulating layer, the first dam layer, and the second dam layer may include a same material.

The first dam layer and the second dam layer may surround a display area of the display panel in a plan view.

The display device may further include a dummy dam layer above the display panel, and spaced from the insulating layer, wherein an edge of the dummy dam layer is aligned with the edge of the display panel, and wherein a dummy groove is defined between the dummy dam layer and the insulating layer.

The display device may further include a dummy dam layer above the display panel, and spaced from the insulating layer, and a first dummy dam layer above the display panel, and between the dummy dam layer and the insulating layer, wherein a first dummy groove is defined between the first dummy dam layer and the insulating layer, and wherein a second dummy groove is defined between the dummy dam layer and the first dummy dam layer.

The display device may further include dummy dam layers between a lower side of the display panel and the insulating layer in a plan view.

The dummy dam layers may be arranged in a direction substantially parallel to the lower side of the display panel.

The dummy dam layers may be arranged in a zigzag form along a direction substantially parallel to the lower side of the display panel.

According to one or more embodiments, a display device includes a display panel including a substrate, and a pixel above the substrate, a first conductive pattern above the display panel, a second conductive pattern above the first conductive pattern, an insulating layer above the second conductive pattern, and a cover layer above the insulating layer, wherein an edge of the insulating layer is spaced from an edge of the substrate, and wherein the cover layer covers the edge of the insulating layer, and directly contacts an upper surface of the substrate adjacent to the edge of the substrate.

The display device may further include a first dam layer above the display panel, and between the edge of the display panel and the insulating layer in a plan view, and a second dam layer above the display panel, and between the edge of the display panel and the first dam layer in a plan view, wherein a first groove is defined between the first dam layer and the insulating layer, wherein a second groove is defined between the second dam layer and the first dam layer, and wherein the cover layer is above the first and second dam layers, and fills the first and second grooves.

The display device may further include a dummy dam layer above the display panel, and spaced from the insulating layer, and a first dummy dam layer above the display panel, and between the dummy dam layer and the insulating layer, wherein a first dummy groove is defined between the first dummy dam layer and the insulating layer, wherein a second dummy groove is defined between the dummy dam layer and the first dummy dam layer, and wherein the cover layer is above the first and second dummy dam layers, and fills the first and second dummy grooves.

According to one or more embodiments of the present invention, a mother panel, especially of a display device, includes a unit panel, a first conductive pattern above the unit panel, a second conductive pattern above the first conductive pattern, an insulating layer above the second conductive pattern, a cover layer above the insulating layer, an adhesion layer above the cover layer, and a reflection reduction layer above the adhesion layer, wherein an edge of the unit panel is defined by a cutting line, wherein a groove overlapping a part of the cutting line is defined in the insulating layer, and wherein the adhesion layer fills the groove.

### BRIEF DESCRIPTION OF THE DRAWINGS

The above and other aspects of the present invention will become apparent by describing in detail embodiments thereof with reference to the accompanying drawings.
FIG. 1 is a perspective view of a display device according to one or more embodiments of the present invention.
FIG. 2 is a view illustrating a cross section of the display device illustrated in FIG. 1.
FIG. 3 is a view illustrating a cross section of a display panel illustrated in FIG. 2.
FIG. 4 is a plan view of the display panel illustrated in FIG. 2.
FIG. 5 is a view illustrating a cross section of a display panel and an input-sensing part corresponding to a pixel illustrated in FIG. 4.
FIG. 6 is a plan view of an input-sensing part illustrated in FIG. 2.
FIG. 7 is an enlarged view of two adjacent first sensing parts and two adjacent second sensing parts illustrated in FIG. 6.
FIG. 8 is a cross-sectional view taken along the line A-A' illustrated in FIG. 7.
FIG. 9 is a cross-sectional view taken along the line I-I' illustrated in FIG. 4.
FIG. 10 is a cross-sectional view taken along the line II-II' illustrated in FIG. 4.
FIG. 11 is a view briefly illustrating a configuration illustrated in FIG. 9.
FIG. 12 is a view illustrating a cross-sectional configuration of a comparative display device.
FIG. 13 is a view illustrating a configuration of a display device according to one or more other embodiments of the present invention.
FIG. 14 is a view briefly illustrating a configuration illustrated in FIG. 13.
FIG. 15 is a view illustrating an external impact test for the display devices illustrated in FIGS. 11 and 14 and the comparative display device illustrated in FIG. 12.
FIG. 16 is a view illustrating a planar configuration of a mother panel according to one or more embodiments of the present invention.
FIG. 17 is an enlarged view of one unit panel illustrated in FIG. 16.
FIG. 18A is a cross-sectional view taken along the line III-III' illustrated in FIG. 17.
FIG. 18B is a view illustrating a unit panel that is cut along a cutting line illustrated in FIG. 18A and is separated from a mother panel.
FIG. 19 is a view illustrating a configuration of a unit panel according to one or more other embodiments of the present invention.
FIG. 20A is a cross-sectional view taken along the line IV-IV' illustrated in FIG. 19.
FIG. 20B is a view illustrating a unit panel that is cut along a cutting line illustrated in FIG. 20A and is separated from a mother panel.
FIG. 21 is a view illustrating a configuration of a unit panel according to one or more other embodiments of the present invention.
FIG. 22A is a cross-sectional view taken along the line V-V' illustrated in FIG. 21.
FIG. 22B is a view illustrating a unit panel that is cut along a cutting line illustrated in FIG. 22A and is separated from a mother panel.
FIG. 23 is a view illustrating a configuration of a unit panel according to one or more other embodiments of the present invention.
FIG. 24A is a cross-sectional view taken along the line VI-VI' illustrated in FIG. 23.
FIG. 24B is a view illustrating a unit panel that is cut along a cutting line illustrated in FIG. 24A and is separated from a mother panel.
FIG. 25 is a view illustrating a configuration of a unit panel according to one or more other embodiments of the present invention.
FIG. 26A is a cross-sectional view taken along the line VII-VII' illustrated in FIG. 25.
FIG. 26B is a view illustrating a unit panel that is cut along a cutting line illustrated in FIG. 26A and is separated from a mother panel.
FIGS. 27A and 27B are views illustrating one or more embodiments modified from the one or more embodiments corresponding to FIGS. 18A and 18B.
FIGS. 28A and 28B are views illustrating one or more embodiments modified from the one or more embodiments corresponding to FIGS. 20A and 20B.
FIGS. 29A and 29B are views illustrating one or more embodiments modified from the one or more embodiments corresponding to FIGS. 22A and 22B.
FIGS. 30A and 30B are views illustrating one or more embodiments modified from the one or more embodiments corresponding to FIGS. 24A and 24B.
FIGS. 31A and 31B are views illustrating one or more embodiments modified from the one or more embodiments corresponding to FIGS. 26A and 26B.
FIGS. 32 and 33 are views illustrating configurations on unit panels according to other embodiments of the present invention.

### DETAILED DESCRIPTION

Aspects of some embodiments of the present invention and methods of accomplishing the same may be understood more readily by reference to the detailed description of embodiments and the accompanying drawings. The described embodiments are provided as examples so that this disclosure will be thorough and complete, and will fully convey the aspects of the present invention to those skilled in the art. Accordingly, processes, elements, and techniques that are redundant, that are unrelated or irrelevant to the description of the embodiments, or that are not necessary to those having ordinary skill in the art for a complete understanding of the aspects of the present invention may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present invention.

A person of ordinary skill in the art would appreciate, in view of the present invention in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the invention is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present invention. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present invention. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present invention. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present invention refers to "one or more embodiments of the present invention."

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

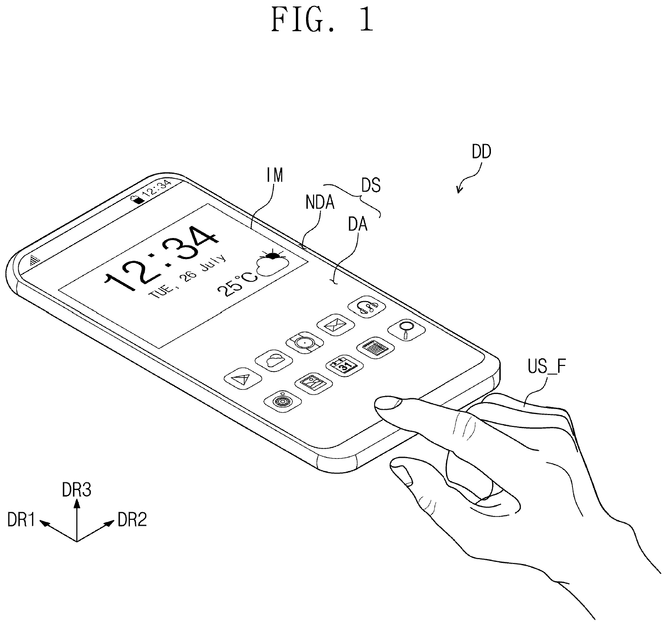

FIG. 1 is a perspective view of a display device according to one or more embodiments of the present invention.

Referring to FIG. 1, a display device DD according to one or more embodiments of the present invention may have a rectangular shape having long sides that extend in a first direction DR1, and short sides that extends in a second direction DR2 that crosses the first direction DR1. However, the display device DD is not limited thereto, and may have various shapes, such as a circular shape or a polygonal shape.

Hereinafter, a direction that substantially perpendicularly crosses a plane that is defined by the first direction DR1 and the second direction DR2 is defined as a third direction DR3. Furthermore, in the specification, a meaning of "when viewed on a plane" is defined as a state viewed in the third direction DR3.

An upper surface of the display device DD may be defined as a display surface DS, and may have a plane that is defined by the first direction DR1 and the second direction DR2. Images IM generated on the display device DD may be provided to the user through the display surface DS. The display device DD may sense a touch of the user through a hand US_F of the user.

The display surface DS may include a display area DA and a non-display area NDA that surrounds the display area DA. The display area DA may display an image, and the non-display area NDA may not display an image. The non-display area NDA may surround the display area DA (e.g., in plan view), and may define an edge of the display device DD that is printed in corresponding color.

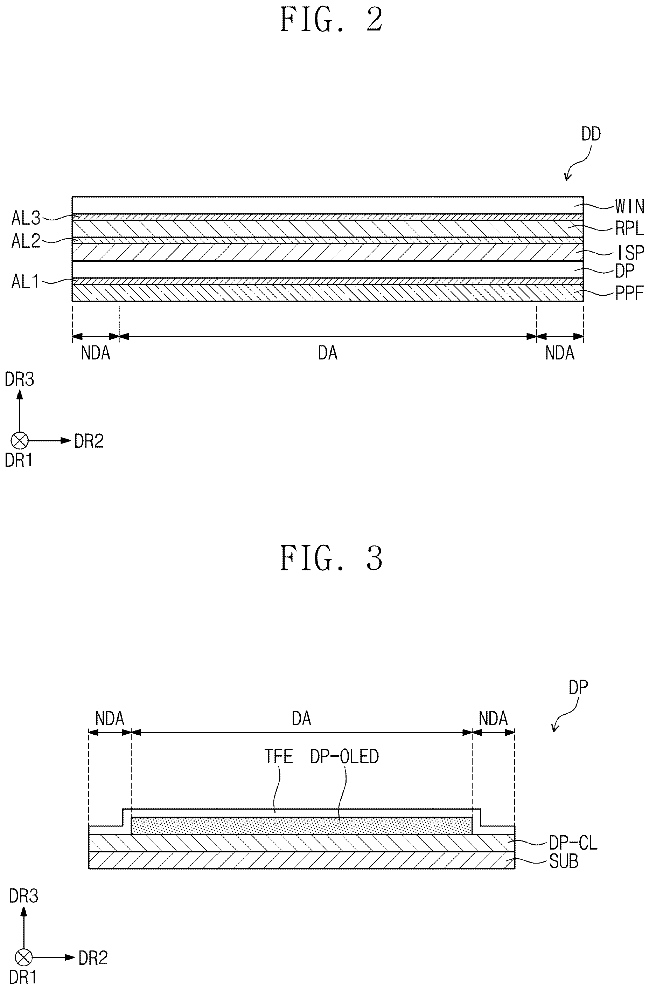

FIG. 2 is a view illustrating a cross section of the display device illustrated in FIG. 1. FIG. 2 illustrates a cross-section of the display device DD viewed in the first direction DR1.

Referring to FIG. 2, the display device DD may include a display panel DP, an input-sensing part ISP, a reflection reduction layer (e.g., a reflection-preventing layer) RPL, a window WIN, a panel protection film PPF, and first and second, and third adhesion layers AL1, AL2, and AL3.

The display panel DP according to one or more embodiments of the present invention may be a light-emitting display panel. For example, the display panel DP may be an organic light-emitting display panel or an inorganic light-emitting display panel. A light-emitting layer of the organic light-emitting display panel may include an organic light-emitting material. A light-emitting layer of the inorganic light-emitting display panel may include quantum dots and quantum rods. Hereinafter, the display panel DP will be described as an organic light-emitting display panel.

An input-sensing part ISP may be located on the display panel DP. In one or more embodiments, the input-sensing part ISP may include a plurality of sensing parts for sensing an external input in a capacitive manner. The input-sensing part ISP may be manufactured directly on the display panel DP when the display device DD is manufactured. However, the present invention is not limited thereto, and the input-sensing part ISP may be manufactured as a panel that is separate from the display panel DP, and may be attached to the display panel DP through an adhesion layer.

A reflection reduction layer RPL may be located on the input-sensing part ISP. The reflection reduction layer RPL may be defined as a film that reduces or prevents reflection of external light. The reflection reduction layer RPL may reduce a reflectance of external light that is input from an upper side of the display device DD toward the display panel DP. The external light may not be visible to the user due to the reflection reduction layer RPL.

When external light that travels toward the display panel DP may be reflected by the display panel DP and may be provided back to the external user, the user may perceive the external light like a mirror. To reduce or prevent the likelihood of this phenomenon, illustratively, the reflection reduction layer RPL may include a plurality of color filters that display the same color as that of the pixels of the display panel DP.

The color filters may filter external light to the same color as that of the pixels. In this case, the external light may not be visible to the user. However, the present invention is not limited thereto, and the reflection reduction layer RPL may include a phase retarder and/or a polarizer to reduce the reflectance of the external light.

The window WIN may be located on the reflection reduction layer RPL. The window WIN may protect the display panel DP, the input-sensing part ISP, and the reflection reduction layer RPL from external scratches and impacts.

The panel protection film PPF may be located under the display panel DP. The panel protection film PPF may protect a lower side of the display panel DP. The panel protection film PPF may include a flexible plastic material, such as polyethyleneterephthalate (PET).

A first adhesion layer AL1 may be located between the display panel DP and the panel protection film PPF, and the display panel DP and the panel protection film PPF may be combined with each other by the first adhesion layer AL1.

A second adhesion layer AL2 may be located between the input-sensing part ISP and the reflection reduction layer RPL, and the input-sensing part ISP and reflection reduction layer RPL may be combined with each other by the second adhesion layer AL2.

The third adhesion layer AL3 may be located between the window WIN and the reflection reduction layer RPL, and the window WIN and the reflection reduction layer RPL may be combined with each other by the third adhesion layer AL3.

FIG. 3 is a view illustrating a cross section of the display panel illustrated in FIG. 2.

FIG. 3 illustrates a cross-section of the display panel DP viewed in the first direction DR1.

Referring to FIG. 3, the display panel DP includes a substrate SUB, a circuit element layer DP-CL that is located on the substrate SUB, a display element layer DP-OLED that is located on the circuit element layer DP-CL, and a thin film encapsulation layer TFE that is located on the display element layer DP-OLED.

The substrate SUB may include a display area DA, and a non-display area NDA around the display area DA. The substrate SUB may include a flexible plastic material, such as glass or polyimide (PI). The display element layer DP-OLED may be located on the display area DA.

A plurality of pixels may be located on the circuit element layer DP-CL and the display element layer DP-OLED. Each of the pixels may include a transistor that is located on a circuit element layer DP-CL, and a light-emitting element that is located on the display element layer DP-OLED and is connected to a transistor.

The thin film encapsulation layer TFE may be located on the circuit element layer DP-CL to cover the display element layer DP-OLED. The thin film encapsulation layer TFE may protect the pixels from moisture, oxygen, and external foreign substances.

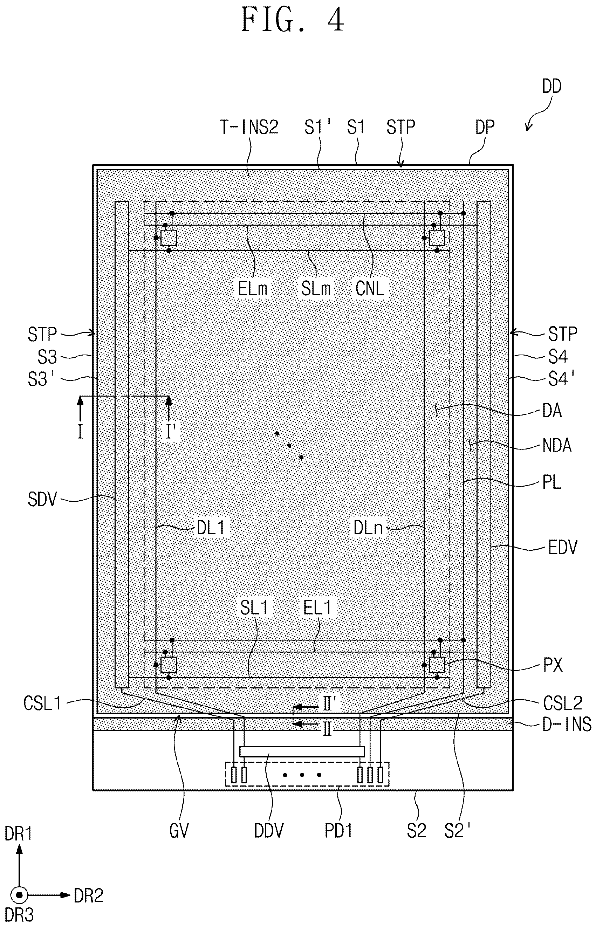

FIG. 4 is a plan view of the display panel illustrated in FIG. 2.

Referring to FIG. 4, the display device DD may include a display panel DP, a scan driver SDV, a data driver DDV, a light emission driver EDV, and a plurality of first pads PD1.

The display panel DP may have a rectangular shape having long sides that extends in the first direction DR1, and short sides that extends in the second direction DR2, but the shape of the display panel DP is not limited to thereto. The display panel DP may include a display area DA, and a non-display area NDA that surrounds the display area DA (e.g., in a plan view).

The display panel DP includes a plurality of pixels PX, a plurality of scan lines SL1 to SLm, a plurality of data lines DL1 to DLn, a plurality of light emission lines EL1 to ELm, first and second control lines CSL1 and CSL2, a power source line PL, and a plurality of connection lines CNL, m and n being natural numbers.

The pixels PX may be located in the display area DA. The scan driver SDV and the light emission driver EDV may be located in the non-display area NDA that is adjacent to the long sides of the display panel DP, respectively. The data driver DDV may be located in the non-display area NDA that is adjacent to one of the short sides of the display panel DP. When viewed on a plane, the data driver DDV may be adjacent to a lower end of the display panel DP.

The scan lines SL1 to SLM may extend in the second direction DR2, and may be connected to the pixels PX and the scan driver SDV. The data lines DL1 to DLn may extend in the first direction DR1, and may be connected to the pixels PX and a data driver DDV. The light emission lines EL1 to ELM may extend in the second direction DR2, and may be connected to the pixels PX and the light emission driver EDV.

The power source line PL may extend in the first direction DR1 and may be located in the non-display area NDA. The power source line PL may be located between the display area DA and the light emission driver EDV, but is not limited thereto, and may be located between the display area DA and the scan driver SDV.

The connection lines CNL may extend in the second direction DR2, and may be arranged in the first direction DR1 to be connected to the power source line PL and the pixels PX. A driving voltage may be applied to the pixels PX through the power source line PL and connection lines CNL that are connected to each other.

The first control line CSL1 may be connected to the scan driver SDV, and may extend toward a lower end of the display panel DP. A second control line CSL2 may be connected to the light emission driver EDV, and may extend toward a lower end of the display panel DP. The data driver DDV may be located between the first control line CSL1 and the second control line CSL2.

The first pads PD1 may be located in the non-display area NDA that is adjacent to a lower end of the display panel DP, and may be closer to the lower end of the display panel DP than the data driver DDV. The data driver DDV, the power source line PL, the first control line CSL1, and the second control line CSL2 may be connected to the first pads PD1. The data lines DL1 to DLN may be connected to a data driver DDV, and the data driver DDV may be connected to the first pads PD1 corresponding to the data lines DL1 to DLN.

In one or more embodiments, the display device DD may further include a timing controller for controlling the operations of the scan driver SDV, the data driver DDV, and the light emission driver EDV. The timing controller may be mounted on the printed circuit board, and may be connected to the first pads PD1 through the printed circuit board.

The scan driver SDV generates a plurality of scan signals, and the scan signals may be applied to the pixels PX through the scan lines SL1 to SLM. The data driver DDV generates a plurality of data voltages, and the data voltages may be applied to the pixels PX through the data lines DL1 to DLN. The light emission driver EDV may generate a plurality of light emission signals, and the light emission signals may be applied to the pixels PX through the light emission lines EL1 to ELM.

The pixels PX may receive data voltages in response to the scan signals. The pixels PX may display an image by emitting light with a luminance corresponding to the data voltages in response to the light emission signals.

The display device DD may include an insulating layer T-INS2 that is located on the display panel DP and a dummy insulating layer D-INS that is located on the display panel DP. Illustratively, in FIG. 4, the insulating layer T-INS2 and the dummy insulating layer D-INS are illustrated in gray.

When viewed on a plane, an edge of the display panel DP may include a first side S1, a second side S2, a third side S3, and a fourth side S4. The first side S1 and the second side S2 may define short sides of the rectangular shape of the display panel DP, and may extend in the second direction DR2. The third side S3 and the fourth side S4 define long sides of the rectangular shape of the display panel DP, and may extend in the first direction DR1.

The first side S1 may be defined as an upper side of the display panel DP, and the second side S2 may be defined as a lower side of the display panel DP. The third side S3 may be defined as a left side of the display panel DP, and the fourth side S4 may be defined as a right side of the display panel DP.

When viewed on a plane, the insulating layer T-INS2 may have a rectangular shape having long sides that extend in the first direction DR1, and short sides that extend in the second direction DR2. The insulating layer T-INS2 may have an area that is larger than the display area DA. The insulating layer T-INS2 may be located on an inside of an edge of the display panel DP. Accordingly, an edge of the insulating layer T-INS2 may be spaced apart from an edge of the display panel DP, and may be located on an inside of an edge of the display panel DP.

The edge of the insulating layer T-INS2 may include a first side S1', a second side S2', a third side S3', and a fourth side S4'. The first side S1' and the second side S2' may define short sides of the rectangular shape of the insulating layer T-INS2, and may extend in the second direction DR2. The third side S3' and the fourth side S4' define long sides of the rectangular shape of the insulating layer T-INS2, and may extend in the first direction DR1.

The first side S1' may be defined as an upper side of the insulating layer T-INS2, and the second side S2' may be defined as a lower side of the insulating layer T-INS2. The third side S3' may be defined as a left side of the insulating layer T-INS2, and the fourth side S4' may be defined as a right side of the insulating layer T-INS2.

The first side S1, the second side S2, the third side S3, and the fourth side S4 may be spaced apart from the first side S1', the second side S2', the third side S3', and the fourth side S4', respectively. A distance between the second side S2 and the second side S2' may be larger than a distance between the first side S1 and the first side S1', larger than a distance between the third side S3 and the third side S3', and larger than a distance between the fourth side S4 and the fourth side S4'.

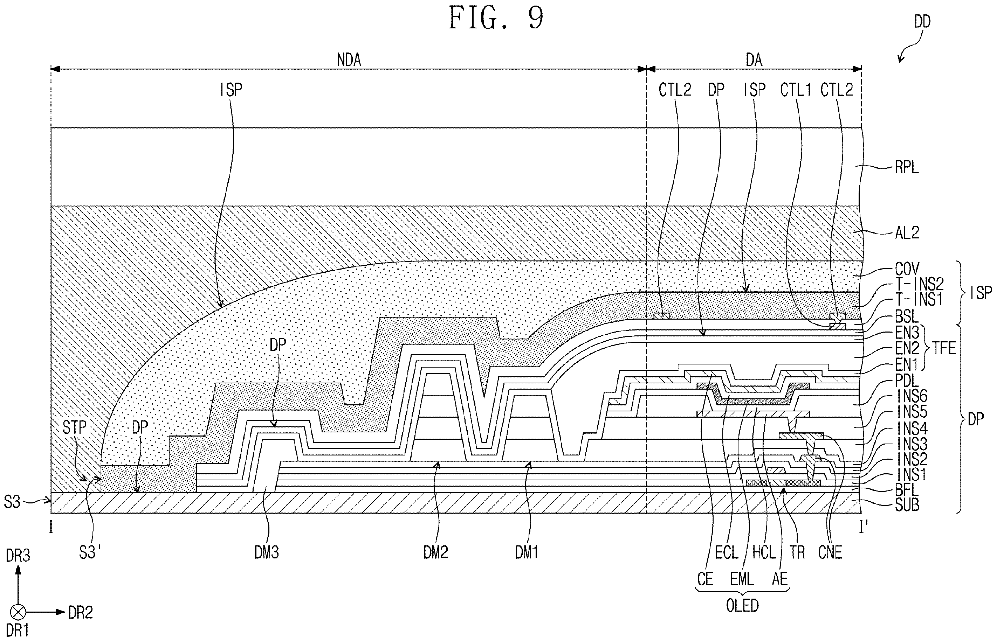

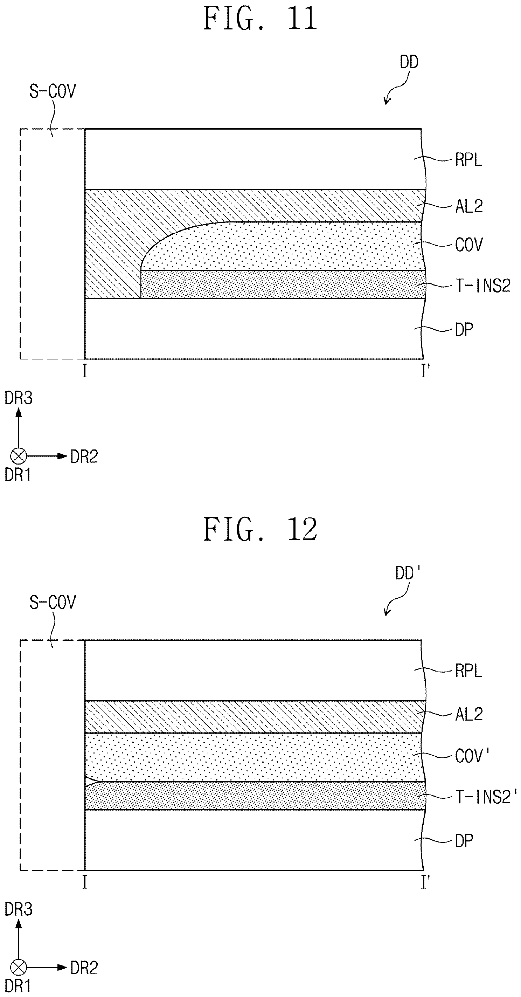

When viewed on a plane, the first side S1, the third side S3, and the fourth side S4 of the display panel DP and the first side S1', the third side S3', and the fourth side S4' of the insulating layer T-INS2 may be defined by a stepped portion STP. A cross-sectional shape of the stepped portion STP will be illustrated in FIGS. 9 and 11 below.

When viewed on a plane, the dummy insulating layer D-INS may be located between the insulating layer T-INS2 and the second side S2 of the display panel DP. The dummy insulating layer D-INS may be spaced apart from the second side S2, and may be located between the data driver DDV and the second side S2' of the insulating layer T-INS2.

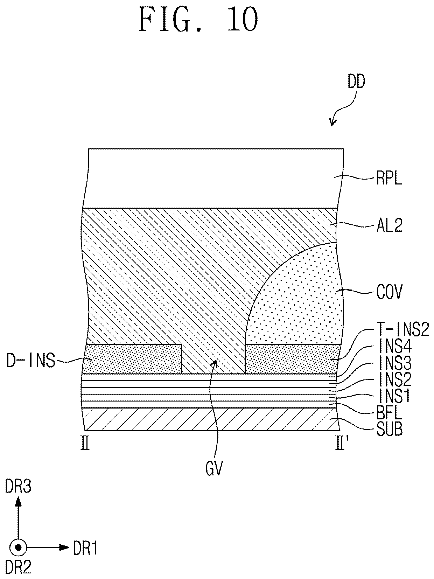

A groove GV may be defined between the dummy insulating layer D-INS and the insulating layer T-INS2. The groove GV may extend in the second direction DR2. The cross-sectional shape of the groove GV will be illustrated in FIG. 10 below. The stepped portion STP and the groove GV may be defined continuously, may have a rectangular closed loop shape, and may surround the display area DA.

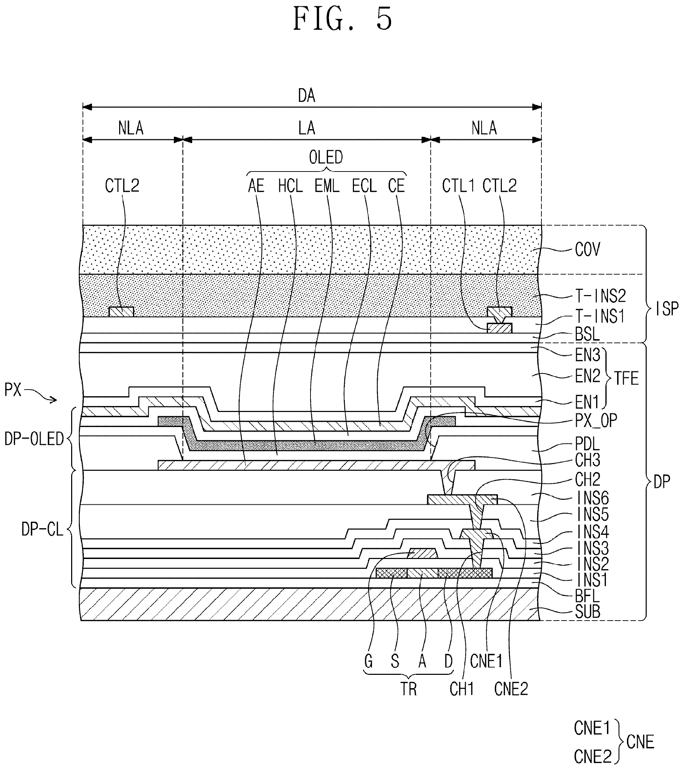

FIG. 5 is a view illustrating a cross section of a display panel and an input-sensing part corresponding to a pixel illustrated in FIG. 4.

Referring to FIG. 5, a pixel PX may be located on the substrate SUB. The pixel PX may include a transistor TR and a light-emitting element OLED. The light-emitting element OLED includes a first electrode AE (or an anode), a second electrode CE (or a cathode), a hole control layer HCL, an electron control layer ECL, and a light-emitting layer EML.

The transistor TR and the light-emitting element OLED may be located on the substrate SUB. Although one transistor TR is illustrated by way of example, substantially, the pixel PX may include a plurality of transistors for driving a light-emitting element OLED and at least one capacitor.

The display area DA may include a light-emitting area LA corresponding to each of the pixels PX, and a non-light-emitting area NLA around the light-emitting area LA. The light-emitting element OLED may be located in the light-emitting area LA.

A buffer layer BFL may be located on the substrate SUB, and the buffer layer BFL may include an inorganic insulating layer. A semiconductor pattern may be located on the buffer layer BFL. The semiconductor pattern may include polysilicon, amorphous silicon, or metal oxide.

The semiconductor pattern may be doped with an N-type dopant or a P-type dopant. The semiconductor pattern may include a high-doping area and a low-doping area. A conductivity of the high-doping area is greater than that of the low-doping area, and may substantially serve as a source electrode and a drain electrode of the transistor TR. The low doped area may substantially correspond to an active (or a channel) of the transistor.

The source "S," the active "A," and the drain "D" of the transistor TR may be formed from a semiconductor pattern. A first insulating layer INS1 may be located on the semiconductor pattern. The gate "G" of the transistor TR may be located on the first insulating layer INS1. A second insulating layer INS2 may be located on the gate "G". A third insulating layer INS3 may be located on the second insulating layer INS2.

Ae connection electrode CNE may include a first connection electrode CNE1 and a second connection electrode CNE2 to connect the transistor TR and the light-emitting element OLED. The first connection electrode CNE1 may be located on the third insulating layer INS3, and may be connected to the drain "D" through the first contact hole CH1 defined in the first to third insulating layers INS1 to INS3.

A fourth insulating layer INS4 may be located on the first connection electrode CNE1. A fifth insulating layer INS5 may be located on the fourth insulating layer INS4. The second connection electrode CNE2 may be located on the fifth insulating layer INS5. The second connection electrode CNE2 may be connected to the first connection electrode CNE1 through a second contact hole CH2 defined in the fourth and fifth insulating layers INS4 and INS5.

A sixth insulating layer INS6 may be located on the second connection electrode CNE2. The layers from the buffer layer BFL to the sixth insulating layer INS6 may be defined as a circuit element layer DP-CL. The first to fourth insulating layers INS1 to INS4 may include an inorganic insulating layer, and the fifth and sixth insulating layers INS5 and INS6 may include an organic insulating layer.

The first electrode AE may be located on the sixth insulating layer INS6. The first electrode AE may be connected to the second connection electrode CNE2 through a third contact hole CH3 defined in the sixth insulating layer INS6. A pixel definition film PDL, in which an opening PX_OP for exposing a corresponding portion of the first electrode AE is defined, may be located on the first electrode AE and the sixth insulating layer INS6.

A hole control layer HCL may be located on the first electrode AE and the pixel definition film PDL. The hole control layer HCL may include a hole transport layer and a hole injection layer.

The light-emitting layer EML may be located on the hole control layer HCL. The light-emitting layer EML may be located in an area corresponding to the opening PX_OP. The light-emitting layer EML may include organic and/or inorganic materials. The light-emitting layer EML may generate any one of red, green, and/or blue light.

The electron control layer ECL may be located on the light-emitting layer EML and the hole control layer HCL. The electron control layer ECL may include an electron transport layer and an electron injection layer. The hole control layer HCL and electron control layer ECL may be commonly located in the light-emitting area LA and the non-light-emitting area NLA.

The second electrode CE may be located on the electron control layer ECL. The second electrode CE may be commonly located in the pixels PX. A layer, on which the light-emitting element OLED is located, may be defined as a display element layer DP-OLED.

The thin film encapsulation layer TFE may be located on the second electrode CE to cover the pixel PX. The thin film encapsulation layer TFE includes a first encapsulation layer EN1 that is located on the second electrode CE, a second encapsulation layer EN2 that is located on the first encapsulation layer EN1, and a third encapsulation layer EN3 that is located on the second encapsulation layer EN2.

The first and third encapsulation layers EN1 and EN3 may include an inorganic insulating layer, and may protect the pixel PX from moisture/oxygen. The second encapsulation layer EN2 includes an organic insulating layer, and may protect the pixel PX from foreign substances, such as dust particles.

A first voltage may be applied to the first electrode AE through the transistor TR, and a second voltage having a level that is lower than the first voltage may be applied to the second electrode CE. Holes and electrons that are injected into the light-emitting layer EML may be combined with each other to form excitons. As the excitons transit to the ground state, the light-emitting element OLED may emit light.

The input-sensing part ISP may be located on the thin film encapsulation layer TFE. The input-sensing part ISP may be located directly on an upper surface of the thin film encapsulation layer TFE.

A base layer BSL may be located on the thin film encapsulation layer TFE. The base layer BSL may include an inorganic insulating layer. At least one inorganic insulating layer may be provided as a base layer BSL on the thin film encapsulation layer TFE.

The input-sensing part ISP may include a first conductive pattern CTL1 that is located on the display panel DP and a second conductive pattern CTL2 that is located on the first conductive pattern CTL1. The first conductive pattern CTL1 may be located on the base layer BSL. A first insulating layer T-INS1 may be located on the base layer BSL to cover the first conductive pattern CTL1. The first insulating layer T-INS1 may include an inorganic insulating layer or an organic insulating layer.

The second conductive pattern CTL2 may be located on the first insulating layer T-INS1. A second insulating layer T-INS2 may be located on the first insulating layer T-INS1 to cover the second conductive pattern CTL2. The second insulating layer T-INS2 may be the insulating layer T-INS2 described in FIG. 4. The second insulating layer T-INS2 may include an organic insulating layer. A cover layer COV may be located on the second insulating layer T-INS2. The cover layer COV may include an organic insulating layer.

The first and second conductive patterns CTL1 and CTL2 may overlap the non-light-emitting area NLA. In one or more embodiments, the first and second conductive patterns CTL1 and CTL2 may be located on the non-light-emitting area NLA between light-emitting areas LA, and may have a mesh shape.

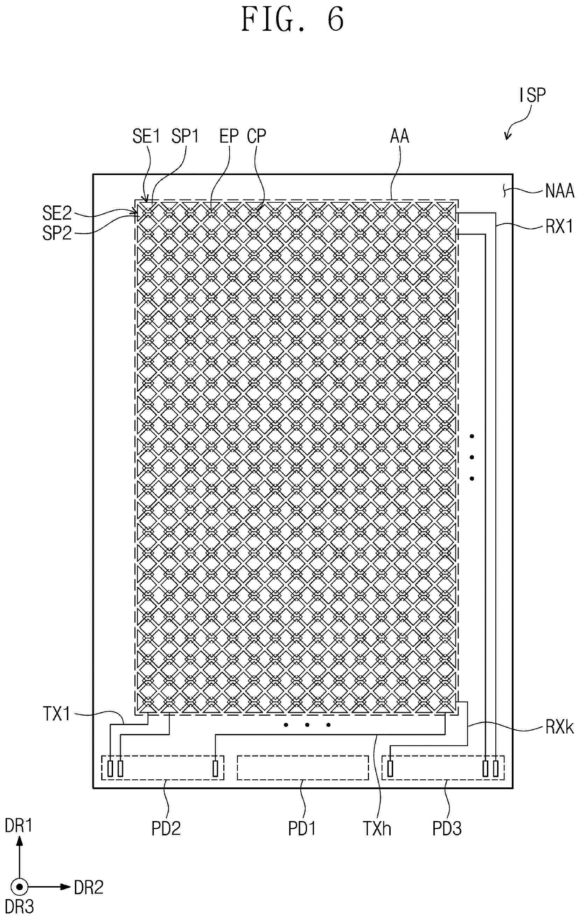

The first and second conductive patterns CTL1 and CTL2 may form sensors of the input-sensing part ISP described above. For example, the first and second mesh-shaped conductive patterns CTL1 and CTL2 may be separated from each other in corresponding area to form sensors. A portion of the second conductive pattern CTL2 may be connected to the first conductive pattern CTL1. The configuration of sensors formed by the first and second conductive patterns CTL1 and CTL2 will be described in detail in FIGS. 6 to 8 below.

FIG. 6 is a plan view of the input-sensing part illustrated in FIG. 2.

Referring to FIG. 6, the input-sensing part ISP includes a plurality of sensing electrodes SE1 and SE2, a plurality of lines TX1 to TXh, a plurality of lines RX1 to RXk, a plurality of second pads PD2, a plurality of second pads PD2, and a plurality of third pads PD3. The sensing electrodes SE1 and SE2, the lines TX1 to TXh and RX1 to RXk, and the second and third pads PD2 and PD3 may be located on the thin film encapsulation layer TFE.

A planar area of the input-sensing part ISP may include an active area AA, and an inactive area NAA that surrounds the active area AA (e.g., in plan view). The active area AA may overlap the display area DA, and the inactive area NAA may overlap with the non-display area NDA.

The sensing electrodes SE1 and SE2 may be located in the active area AA, and the second and third pads PD2 and PD3 may be located in the inactive area NAA. The second pads PD2 and third pads PD3 may be adjacent to a lower end of the input-sensing part ISP when viewed on a plane. When viewed on a plane, the first pads PD1 may be located between the second pads PD2 and the third pads PD3.

The lines TX1 to TXh, and RX1 to RXk may be connected to ends of the sensing electrodes SE1 and SE2, and may extend to the inactive area NAA and may be connected to the second and third pads PD2 and PD3. In one or more embodiments, the sensing control unit that controls the input-sensing part ISP may be connected to the second and third pads PD2 and PD3 through a printed circuit board.

The sensing electrodes SE1 and SE2 include a plurality of first sensing electrodes SE1 that extend in the first direction DR1, and that are arranged in the second direction DR2, and a plurality of second sensing electrodes SE2 that extend in the second direction DR2 and are arranged in the first direction. The second sensing electrodes SE2 may extend to cross the first sensing electrodes SE1 while being insulated therefrom.

The lines TX1 to TXh, and RX1 to RXk include a plurality of first lines TX1 to TXh that are connected to the first sensing electrodes SE1 and a plurality of second lines RX1 to RXk that are connected to the second sensing electrodes SE2 "h" and "k" being natural numbers. The first lines TX1 to TXh may extend to the inactive area NAA, and may be connected to the second pads PD2. The second lines RX1 to RXk may extend to the inactive area NAA, and may be connected to the third pads PD3.

Illustratively, when viewed on a plane, the first lines TX1 to TXh may be located in the inactive area NAA that is adjacent to the lower side of the active area AA. When viewed on a plane, the second lines RX1 to RXk may be located in the inactive area NAA that is adjacent to the right side of the active area AA. The first lines TX1 to TXh may be defined as transmission lines, and the second lines RX1 to RXk may be defined as sensing lines.

Each of the first sensing electrodes SE1 may include a plurality of first sensing parts SP1 that are located in the first direction DR1, and a plurality of connection patterns CP that connect the first sensing parts SP1. Each of the connection patterns CP is located between two first sensing parts SP1 that are adjacent to each other in the first direction DR1 to connect the two first sensing parts SP1.

Each of the second sensing electrodes SE2 may include a plurality of second sensing parts SP2 that are located in the second direction DR2, and a plurality of extension patterns EP that extend from the second sensing parts SP2. Each of the extension patterns EP may be located between two second sensing parts SP2 that are adjacent to each other in the second direction DR2, and may extend from the two second sensing parts SP2.

The first sensing parts SP1 and the second sensing parts SP2 do not overlap each other but may be spaced apart from each other, and may be located alternately. An electrostatic capacitance may be formed by the first sensing parts SP1 and the second sensing parts SP2. Extension patterns EP may not overlap connection patterns CP.

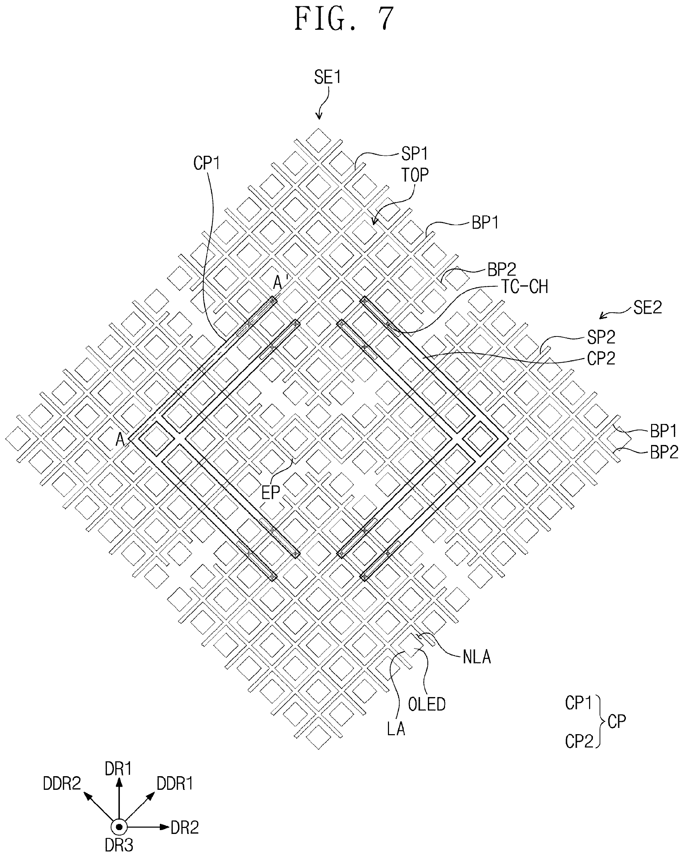

FIG. 7 is an enlarged view of two adjacent first sensing parts and two adjacent second sensing parts illustrated in FIG. 6.

Referring to FIG. 7, the first sensing parts SP1 and the second sensing parts SP2 may have a mesh shape. To have a mesh shape, each of the first and second sensing parts SP1 and SP2 may include a plurality of first branch portions BP1 that extend in a first diagonal direction DDR1, and a plurality of second branch portions BP2 that extend in a second diagonal direction DDR2.

The first diagonal direction DDR1 may be defined as a direction that crosses the first and second directions DR1 and DR2 on a plane that is defined by the first and second directions DR1 and DR2. The second diagonal direction DDR2 may be defined as a direction that crosses the first diagonal direction DDR1 on a plane that is defined by the first and second directions DR1 and DR2. Illustratively, the first direction DR1 and the second direction DR2 may cross each other substantially perpendicularly, and the first diagonal direction DDR1 and the second diagonal direction DDR2 may cross each other substantially perpendicularly.

A first branch portions BP1 of each of the first and second sensing parts SP1 and SP2 may cross a second branch portions BP2 of each of the first and second sensing parts SP1 and SP2, and may be formed integrally with each other. Diamond-shaped touch openings TOP may be defined by the first branch portions BP1 and the second branch portions BP2.

When viewed on a plane, light-emitting areas LA may be located in the touch openings TOP. Light-emitting elements OLED may be located in light-emitting areas LA. Each of the light-emitting areas LA may be the light-emitting area LA illustrated in FIG. 5. The first and second sensing parts SP1 and SP2 may be located in a non-light-emitting area NLA. Because the first and second sensing parts SP1 and SP2 are located in the non-light-emitting area NLA, the light generated in the light-emitting areas LA may be normally output while not being influenced by the first and second sensing parts SP1 and SP2.

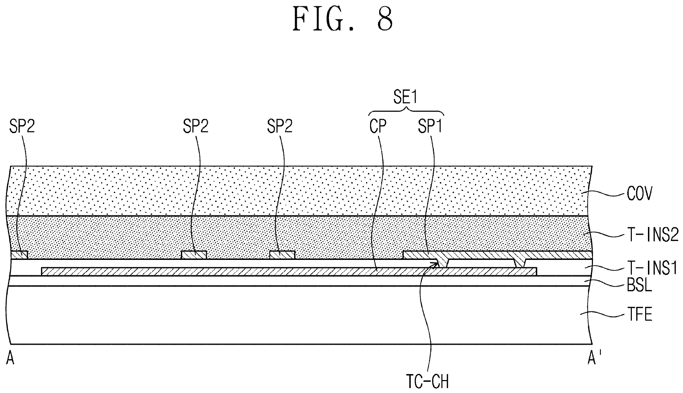

The connection pattern CP may extend not to overlap the extension pattern EP to connect the first sensing parts SP1. The connection pattern CP may be connected to the first sensing parts SP1 through a plurality of contact holes TC-CH. The structure of the contact holes TC-CH will be illustrated in FIG. 8 below. The connection pattern CP may extend toward the first sensing parts SP1 via areas that overlap the second sensing parts SP2.

The extension pattern EP may be located between adjacent ones of the first sensing parts SP1, and may extend from the second sensing parts SP2. The second sensing parts SP2 and the extension pattern EP may be formed integrally. The extension pattern EP may have a mesh shape.

The extension pattern EP, the first sensing parts SP1, and the second sensing parts SP2 may be located on the same layer, and may be formed by concurrently or substantially simultaneously patterning the same material. The connection pattern CP may be located on a different layer from the extension pattern EP, the first sensing parts SP1, and the second sensing parts SP2.

The connection pattern CP may include a first connection pattern CP1 and a second connection pattern CP2 that have shapes that are symmetrical to each other in the second direction DR2. The extension pattern EP may be located between the first connection pattern CP1 and the second connection pattern CP2. The first connection pattern CP1 and the second connection pattern CP2 may have a bent shape.

The first connection pattern CP1 may extend toward the first sensing parts SP1 via one of the two second sensing parts SP2. The second connection pattern CP2 may extend toward the first sensing parts SP1 via a second sensing part SP2 of the other of the two second sensing parts SP2.

Contact holes TC-CH may be adjacent to opposite ends of the first connection pattern CP1 and opposite ends of the second connection pattern CP2. When viewed on a plane, the contact holes TC-CH may overlap the first sensing parts SP1. The first connection pattern CP1 and the second connection pattern CP2 may be connected to the first sensing parts SP1 through the contact holes TC-CH.

In one or more embodiments, the bent portion of the first connection pattern CP1, and the bent portion of the second connection pattern CP2 may overlap the second sensing parts SP2. A single touch opening TOP may be defined in each of the bent portion of the first connection pattern CP1 and the bent portion of the second connection pattern CP2. Each of the first connection pattern CP1 and the second connection pattern CP2 may include two mesh lines that extend toward the first sensing parts SP1, in one or more embodiments.

FIG. 8 is a cross-sectional view taken along the line A-A' illustrated in FIG. 7.

Referring to FIGS. 7 and 8, a base layer BSL may be located on the thin film encapsulation layer TFE (as used herein, "located on" may mean "above"). A connection pattern CP may be located on the base layer BSL. A first insulating layer T-INS1 may be located on the connection pattern CP and the base layer BSL. The first insulating layer T-INS1 may be located on the base layer BSL to cover the connection pattern CP. The connection pattern CP may be defined as the first conductive pattern CTL1 described above.

A first sensing part SP1 and a second sensing part SP2 may be located on the first insulating layer T-INS1. An extension pattern EP that is formed integrally with the second sensing part SP2 may also be located on the first insulating layer T-INS1. The connection pattern CP may be connected to the first sensing part SP1 through a plurality of contact holes TC-CH defined in the first insulating layer T-INS1.

The extension pattern EP, the first sensing part SP1, and the second sensing part SP2 may be located on the first insulating layer T-INS1, and may be located in the same layer. The extension pattern EP, the first sensing part SP1, and the second sensing part SP2 may be defined as the above-described second conductive pattern CTL2. The connection pattern CP may be located under the extension pattern EP, the first sensing part SP1, and the second sensing part SP2.

A second insulating layer T-INS2 may be located on the first and second sensing parts SP1 and SP2 and the first insulating layer T-INS1, and a cover layer COV may be located on the second insulating layer T-INS2.

FIG. 9 is a cross-sectional view taken along the line I-I' illustrated in FIG. 4.

Referring to FIG. 9, the buffer layer BFL and the first to fourth insulating layers INS1 to INS4 may extend toward the non-display area NDA. Peripheries of the buffer layer BFL and the first to fourth insulating layers INS1 to INS4 may be spaced apart from an edge of the substrate SUB.

The fifth and sixth insulating layers INS5 and INS6 may extend to a portion of the non-display area NDA, which is adjacent to the display area DA. The buffer layer BFL and the first to fourth insulating layers INS1 to INS4 may extend to the non-display area NDA further than the fifth and sixth insulating layers INS5 and INS6. The pixel definition film PDL may not extend to the non-display area NDA.

The display panel DP may include a first dam DM1, a second dam DM2, and a third dam DM3 that are sequentially spaced from the display area DA. In the non-display area NDA, the first dam DM1 and the second dam DM2 may be located on the fourth insulating layer INS4. The first dam DM1 may be located between the second dam DM2 and the display area DA. In the non-display area NDA, the first dam DM1 may be located between the second dam DM2 and the side surfaces of the fifth and sixth insulating layers INS5 and INS6.

The second dam DM2 may be higher (e.g., thicker) than the first dam DM1. For example, the first dam DM1 may be formed of three layers that are stacked on each other, and the second dam DM2 may be formed of four layers that are stacked on each other.

In one or more embodiments, the first dam DM1 may include layers that are formed of the same material as that of the fifth insulating layer INS5, the sixth insulating layer INS6, and the pixel definition film PDL. In one or more embodiments, the second dam DM2 may include layers that are formed of the same material as that of the fifth insulating layer INS5, the sixth insulating layer INS6, and the pixel definition film PDL. Furthermore, the second dam DM2 may further include a layer (e.g., an organic layer) that is located higher than the pixel definition film PDL.

The third dam DM3 may be located between the second dam DM2 and the edge of the substrate SUB. The third dam DM3 may be located on the fourth insulating layer INS4. The third dam DM3 may cover the peripheries of the buffer layer BFL and the first to fourth insulating layers INS1 to INS4. The third dam DM3 may be formed of the same material as that of the fifth insulating layer INS5.

The hole control layer HCL, the electron control layer ECL, and the second electrode CE may extend to the non-display area NDA that is adjacent to the display area DA and may be located on the sixth insulating layer INS6.

The first encapsulation layer EN1 may be extended to the non-display area NDA. In the non-display area NDA, the first encapsulation layer EN1 may be located on the fourth insulating layer INS4 to cover the first dam DM1 and the second dam DM2. Furthermore, the first encapsulation layer EN1 may be located on the substrate SUB to cover the third dam DM3.

The second encapsulation layer EN2 may extend to the non-display area NDA. The second encapsulation layer EN2 may be located up to the first dam DM1. The first encapsulation layer EN1 may extend to the non-display area NDA further than the second encapsulation layer EN2.

When a display device DD is manufactured, an organic material having fluidity may be cured to form a second encapsulation layer EN2. Even when fluid organic material flows to the non-display area NDA, it may be blocked at the first dam DM1. In one or more embodiments, the organic material that overflows the first dam DM1 may be further blocked at the second dam DM2.

The third encapsulation layer EN3 may extend to the non-display area NDA. The third encapsulation layer EN3 may be located on the first encapsulation layer EN1 and the second encapsulation layer EN2 in the non-display area NDA.

The base layer BSL may extend to the non-display area NDA, and may be located on the third encapsulation layer EN3. The first insulating layer T-INS1 may extend to the non-display area NDA, and may be located on the base layer BSL.

The peripheries of the first and third encapsulation layers EN1 and EN3, the base layer BSL, and the first insulating layer T-INS1 may be spaced apart from the edge of the substrate SUB. In the non-display area NDA, the peripheries of the first and third encapsulation layers EN1 and EN3, the base layer BSL, and the first insulating layer T-INS1 may overlap each other.

The second insulating layer T-INS2 may extend to the non-display area NDA, and may be located on the first insulating layer T-INS1. In the non-display area NDA, the second insulating layer T-INS2 may be located to cover the peripheries of the first and third encapsulation layers EN1 and EN3, the base layer BSL, and the first insulating layer T-INS1. The second insulating layer T-INS2 may directly contact an upper surface of the substrate SUB, which is adjacent to the side surfaces of the first and third encapsulation layers EN1 and EN3, the base layer BSL, and the first insulating layer T-INS1. The edge of the second insulating layer T-INS2 may be spaced apart from the edge of the substrate SUB.

The cover layer COV may extend to the non-display area NDA, and may be located on the second insulating layer T-INS2. The edge of the cover layer COV may be spaced apart from the edge of the substrate SUB. The edge of the cover layer COV may overlap the edge of the second insulating layer T-INS2. Accordingly, the cover layer COV may be located to overlap the insulating layer T-INS2 illustrated in gray in FIG. 4 (e.g., the second insulating layer T-INS2) when viewed on a plane.

A second adhesion layer AL2 may be located on the cover layer COV. A reflection reduction layer RPL is located on the second adhesion layer AL2, and the reflection reduction layer RPL may be attached to the cover layer COV by the second adhesion layer AL2.

In the non-display area NDA, the second adhesion layer AL2 may be located on the substrate SUB to cover the peripheries of the second insulating layer T-INS2 and the cover layer COV. The second adhesion layer AL2 may directly contact an upper surface of the substrate SUB, which is adjacent to the edge of the substrate SUB. The edge of the second adhesion layer AL2 may overlap the edge of the substrate SUB.

The stepped portion STP may be defined by the edge of the substrate SUB, which defines the edge of the display panel DP, and the edge of the second insulating layer T-INS2. For example, the stepped portion STP may be defined by the edge (e.g., the third side S3) of the substrate SUB and the edge (e.g., the third side S3') of the second insulating layer T-INS2, which are located at different heights.

Substantially, the edge of the substrate SUB, which defines the stepped portion STP, may be the first side S1, the third side S3, and the fourth side S4 illustrated in FIG. 4 described above. Furthermore, the edge of the second insulating layer T-INS2, which defines the stepped portion STP, may be the first side S1', the third side S3', and the fourth side S4' illustrated in FIG. 4 described above.

FIG. 10 is a cross-sectional view taken along the line II-II' illustrated in FIG. 4.

Referring to FIG. 10, the second insulating layer T-INS2 and the dummy insulating layer D-INS may be located on the fourth insulating layer INS4. A groove GV may be defined between the second insulating layer T-INS2 and the dummy insulating layer D-INS. The second insulating layer T-INS2 and the dummy insulating layer D-INS may be formed concurrently or substantially simultaneously of substantially the same material.

FIG. 11 is a view briefly illustrating the configuration illustrated in FIG. 9.

For convenience of description, the display panel DP in FIG. 11 is illustrated as a single layer. Furthermore, the layer between the second insulating layer T-INS2 and the display panel DP is omitted.

Referring to FIG. 11, the edge of the second insulating layer T-INS2 and the edge of the cover layer COV may overlap each other, or may be aligned with each other, may be spaced apart from the edge of the display panel DP, and may be located on an inside of the edge of the display panel DP.

The display device DD may further include a side cover layer S-COV that is located on, or that contacts, the side surfaces of the display panel DP, of the second adhesion layer AL2, and of the reflection reduction layer RPL. Illustratively, the side cover layer S-COV is illustrated as a dotted line. The side cover layer S-COV may include an organic insulating layer. The side cover layer S-COV may absorb an external impact.

FIG. 12 is a view illustrating a cross-sectional configuration of a comparative display device. FIG. 12 is illustrated in a cross section corresponding to FIG. 11.

Referring to FIG. 12, an edge of the second insulating layer T-INS2' and an edge of the cover layer COV' of the comparative display device DD' may overlap an edge of the display panel DP. When a side cover layer S-COV is not located, the edge of the second insulating layer T-INS2' and the edge of the cover layer COV' may be exposed to an outside.

An external impact may be applied to the side cover layer S-COV. The side cover layer S-COV may absorb an external impact, but when the external impact is large, the amount of impact that is delivered to the edge of the second insulating layer T-INS2' and the edge of the cover layer COV' may increase.

When the amount of impact delivered to the edge of the second insulating layer T-INS2' and the edge of the cover layer COV' is large enough to damage the second insulating layer T-INS2' and the cover layer COV', the edge of the second insulating layer T-INS2' and the edge of the cover layer COV' may be delaminated. Accordingly, the side surface of the comparative display device DD' may be damaged.

Referring to FIG. 11, the edge of the second insulating layer T-INS2 and the edge of the cover layer COV may be spaced apart from the edge of the display panel DP, and the second adhesion layer AL2 may cover the edge of the second insulating layer T-INS2 and the edge of the cover layer COV.

Even when an external impact is applied to the side cover layer S-COV, the side cover layer S-COV and the second adhesion layer AL2 may dually absorb the external impact. Accordingly, the amount of external impact delivered to the edge of the second insulating layer T-INS2 and the edge of the cover layer COV may be reduced, and thus, the edge of the second insulating layer T-INS2 and the edge of the cover layer COV may not be delaminated. Accordingly, a side portion of the display device DD may not be damaged.

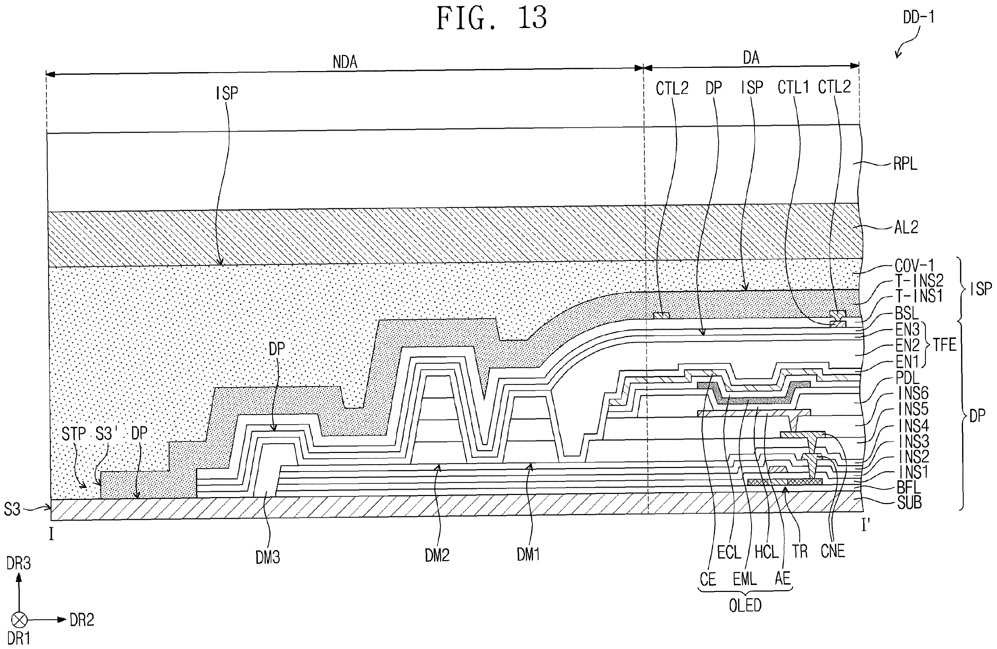

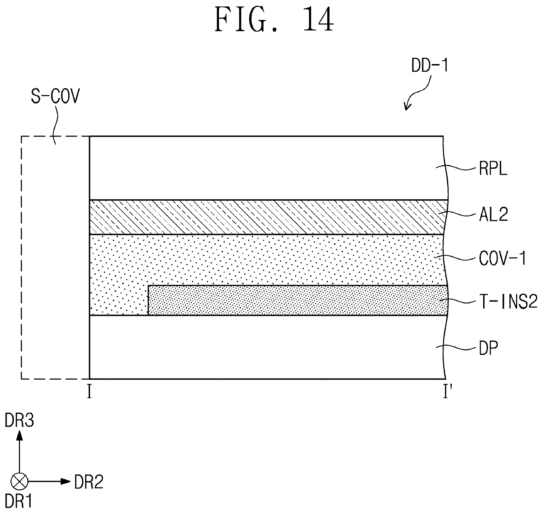

FIG. 13 is a view illustrating the configuration of a display device according to one or more other embodiments of the present invention. FIG. 14 is a view briefly illustrating the configuration illustrated in FIG. 13.

FIG. 13 is illustrated in a cross section corresponding to FIG. 9, and FIG. 14 is illustrated in a cross section corresponding to FIG. 11. Hereinafter, the configurations illustrated in FIGS. 13 and 14 will be described, focusing on configurations different from those illustrated in FIGS. 9 and 11.

Referring to FIG. 13, the edge of the second insulating layer T-INS2 may be spaced apart from the edge of the substrate SUB. A cover layer COV-1 of the display device DD-1 may be located on the substrate SUB to cover the edge of the second insulating layer T-INS2. The cover layer COV-1 may directly contact an upper surface of the substrate SUB, which is adjacent to the edge of the substrate SUB. The edge of the cover layer COV-1 may overlap the edge of the substrate SUB. The second adhesion layer AL2 may be located on the cover layer COV-1 that covers the edge of the second insulating layer T-INS2.

Referring to FIG. 14, the edge of the second insulating layer T-INS2 may be spaced apart from the edge of the display panel DP, and the cover layer COV-1 may be located on the display panel DP to cover the edge of the second insulating layer T-INS2. The edge of the cover layer COV-1 and the edge of the second adhesion layer AL2 may overlap the edge of the display panel DP. Because an external impact may be absorbed by the side cover layer S-COV and the cover layer COV-1, the amount of impact delivered to the second insulating layer T-INS2 may be reduced.

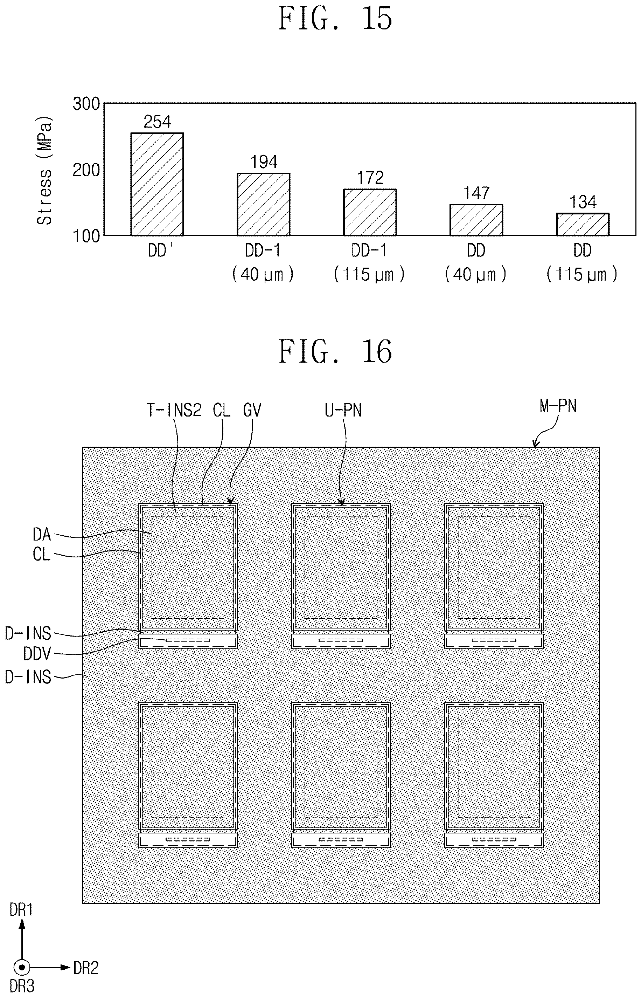

FIG. 15 is a view illustrating an external impact test for the display devices illustrated in FIGS. 11 and 14 and the comparative display device illustrated in FIG. 12.

In FIG. 15, the vertical axis represents stress, and the stress may be in units of megapascals (MPA). The stress may substantially correspond to the amount of impact delivered to the second insulating layer T-INS2. Furthermore, in FIG. 15, the values illustrated on the display devices DD and DD-1 may represent a distance between the edge of the substrate SUB and the edge of the second insulating layer T-INS2.

Referring to FIG. 15, the amount of impact delivered to the second insulating layer T-INS2' from the display devices DD and DD-1 may be reduced as compared to the amount of impact delivered to the second insulating layer T-INS2' from the comparative display device DD'. Furthermore, in FIG. 15, as the distance between the edge of the substrate SUB and the edge of the second insulating layer T-INS2 becomes larger, that is, as the edge of the second insulating layer T-INS2 becomes spaced further apart from the edge of the substrate SUB, the amount of impact delivered to the second insulating layer T-INS2 may be reduced.

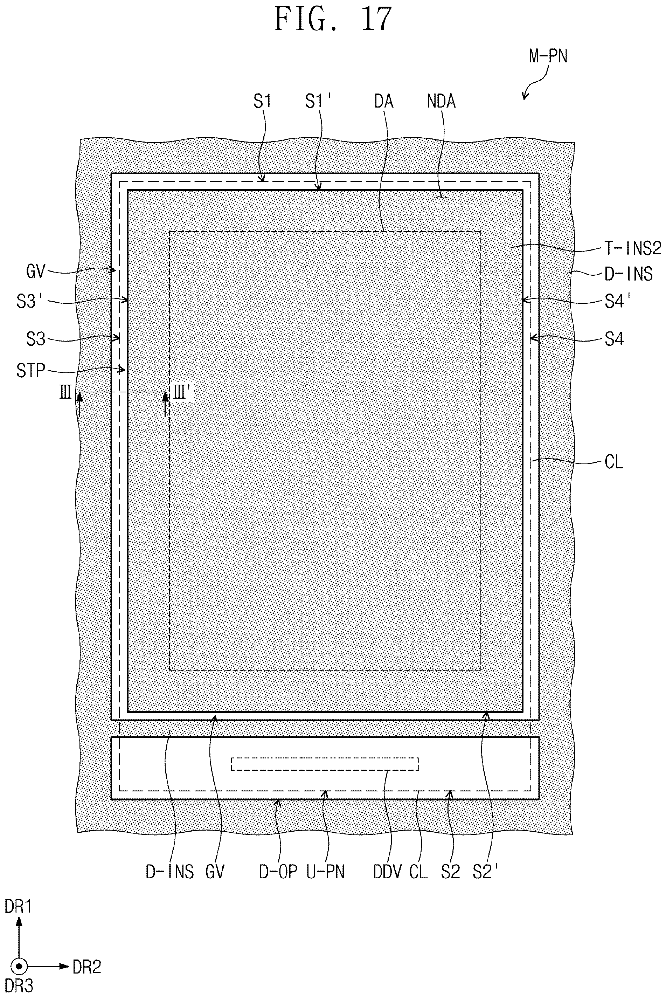

FIG. 16 is a view illustrating a planar configuration of a mother panel according to one or more embodiments of the present invention. FIG. 17 is an enlarged view of any one unit panel illustrated in FIG. 16.

Referring to FIG. 16, a mother panel M-PN may include a plurality of unit panels U-PN that are arranged in the first direction DR1 and the second direction DR2. Each of the unit panels U-PN may be the display panel DP described above. In FIG. 16, the display area DA and the data driver DDV are illustrated as dotted lines.

The edge of each of the unit panels U-PN is illustrated as a dotted line. The edge of each of the unit panels U-PN may be defined as a cutting line CL. That is, the cutting line CL is illustrated as a dotted line. Along the cutting line CL of each of the unit panels U-PN, the mother panel M-PN is cut, and thus, the unit panels U-PN may be separated from the mother panel M-PN. Accordingly, the cutting line CL may correspond to the first to fourth sides S1, S2, S3, and S4 of the display panel DP described above.

Substantially, after the above-described input-sensing parts ISP and the reflection reduction layer RPL are located on the unit panels U-PN, the unit panels U-PN may be separated from the mother panel M-PN. When the unit panels U-PN are separated, the input-sensing parts ISP may also be separated from each other, and the reflection reduction layers RPL may also be separated from each other.

A second insulating layer T-INS2 and a dummy insulating layer D-INS may be located on each of the unit panels U-PN. A groove GV may be defined between the second insulating layer T-INS2 and the dummy insulating layer D-INS. The configuration will be illustrated and described in more detail in FIG. 17 below.

Referring to FIG. 17, the groove GV may be defined on the unit panel U-PN, and the groove GV may correspond to the stepped portion STP and the groove GV illustrated in FIGS. 4, 9, and 10. A portion of the groove GV illustrated in FIG. 17 (e.g., the groove GV defined between the second side S2' and the dummy insulating layer D-INS) may remain on the display panel DP, and thus, the groove GV illustrated in FIG. 4 may be defined.

Accordingly, the groove GV illustrated in FIGS. 16 and 17 is denoted by using the same reference numeral as that of the groove GV illustrated in FIG. 4. For example, to illustrate and describe the shape of the groove GV in FIG. 17 more clearly, the groove GV illustrated in FIG. 17 is illustrated to be relatively larger than the groove GV illustrated in FIG. 4.

A dummy insulating layer D-INS may be located around the second insulating layer T-INS2 to surround the second insulating layer T-INS2. A groove GV may be defined between the second insulating layer T-INS2 and the dummy insulating layer D-INS. The groove GV may be defined as a generally rectangular closed loop shape corresponding to the shape of the second insulating layer T-INS2.

The groove GV may overlap a part of the cutting line CL. For example, the groove GV may overlap the cutting line CL that is adjacent to each of the first side S1', the third side S3', and the fourth side S4'.

The groove GV that overlaps the cutting line CL that is adjacent to the first side S1' may extend in the second direction DR2. The groove GV that overlaps the cutting line CL that is adjacent to each of the third side S3' and the fourth side S4' may extend in the first direction DR1. The groove GV that is spaced apart from the second side S2 and that is defined between the second side S2' and the dummy insulating layer D-INS may extend in the second direction DR2.

A width of the groove GV that overlaps the cutting line CL that is adjacent to the first side S1', the third side S3', and the fourth side S4' may be larger than a width of the groove GV that is defined between the second side S2' and the dummy insulating layers D-INS. In the specification, a "width" may be defined as a value that is measured in a direction that crosses an extension direction of the configuration.

When the unit panel U-PN is separated from the mother panel M-PN, the above-described stepped portion STP may be formed at a part that is cut along the cutting line CL that is adjacent to the first side S1', the third side S3', and the fourth side S4'. When the unit panel U-PN is separated from the mother panel M-PN, the groove GV defined between the second side S2' and the dummy insulating layer D-INS may remain on the unit panel U-PN.

An opening D-OP may be defined in the dummy insulating layer D-INS. An opening D-OP may expose a data driver DDV. The opening D-OP may expose a part of the unit panel U-PN that is adjacent to the data driver DDV. The groove GV may be defined between the opening D-OP and the display area DA.

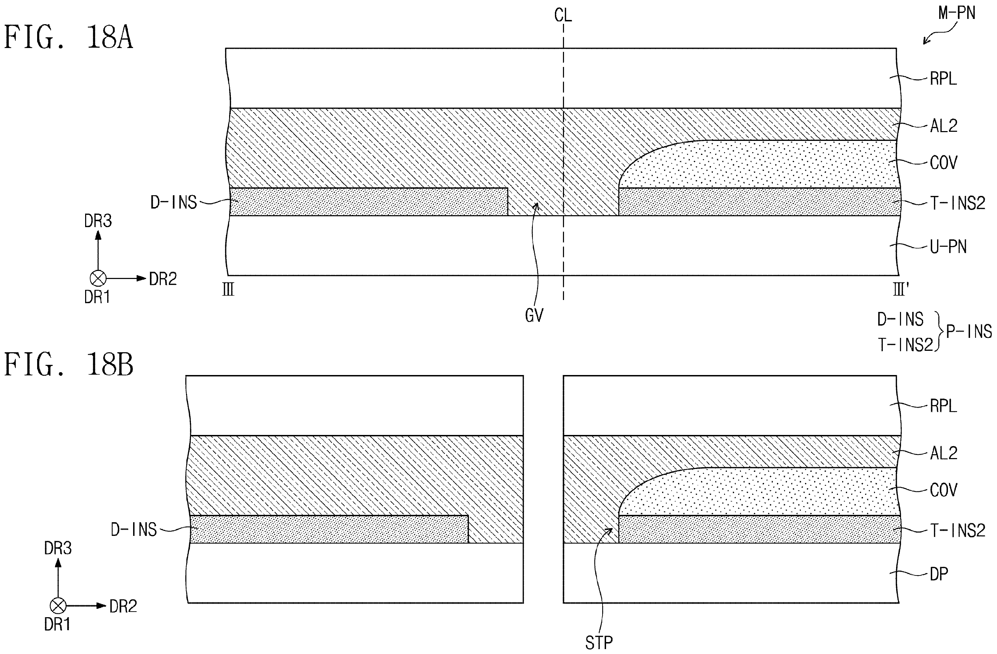

FIG. 18A is a cross-sectional view taken along the line III-III' illustrated in FIG. 17. FIG. 18B is a view illustrating a unit panel that is cut along the cutting line illustrated in FIG. 18A and is separated from the mother panel. FIG. 18A is illustrated in a simplified manner similar to FIG. 11.

Referring to FIG. 18A, an insulating layer P-INS may be located on the unit panel U-PN. A groove GV that overlaps the cutting line CL may be defined in the insulating layer P-INS. The insulating layer P-INS may be separated into a second insulating layer T-INS2 and a dummy insulating layer D-INS by the groove GV. Accordingly, the second insulating layer T-INS2 and the dummy insulating layer D-INS may be formed concurrently or substantially simultaneously of the same material.

In one or more embodiments, the first conductive pattern CTL1 and the second conductive pattern CTL2 illustrated in FIG. 9 may be located on the unit panel U-PN, and the insulating layer P-INS may be located on the second conductive pattern CTL2. For example, the second insulating layer T-INS2 of the insulating layer P-INS may be located on the second conductive pattern CTL2.

A cover layer COV may be located on the insulating layer P-INS. For example, the cover layer COV may be located on the second insulating layer T-INS2 of the insulating layer P-INS. An organic ink with fluidity may be provided on the second insulating layer T-INS2, and the organic ink may be cured to form the cover layer COV.

When the organic ink is provided on the second insulating layer T-INS2, the organic ink may be located to the edge of the second insulating layer T-INS2 depending on a surface tension thereof, and a side surface of the organic ink may have a curved shape. Accordingly, the side surface of the cover layer COV formed by curing the organic ink may also have a curved shape. When the organic ink is excessively provided on the second insulating layer T-INS2, the organic ink may overflow past the second insulating layer T-INS2. In this case, organic ink that overflows the second insulating layer T-INS2 may be accommodated in the groove GV.

The second adhesion layer AL2 may be located on the cover layer COV and the dummy insulating layer D-INS, and the reflection reduction layer RPL may be located on the second adhesion layer AL2. The second adhesion layer AL2 may be located on the unit panel U-PN to fill the groove GV.

Referring to FIGS. 18A and 18B, the mother panel M-PN may be cut along the cutting line CL, and the unit panel U-PN may be separated from the mother panel M-PN. The unit panel U-PN separated from the mother panel M-PN may be defined as a display panel DP.

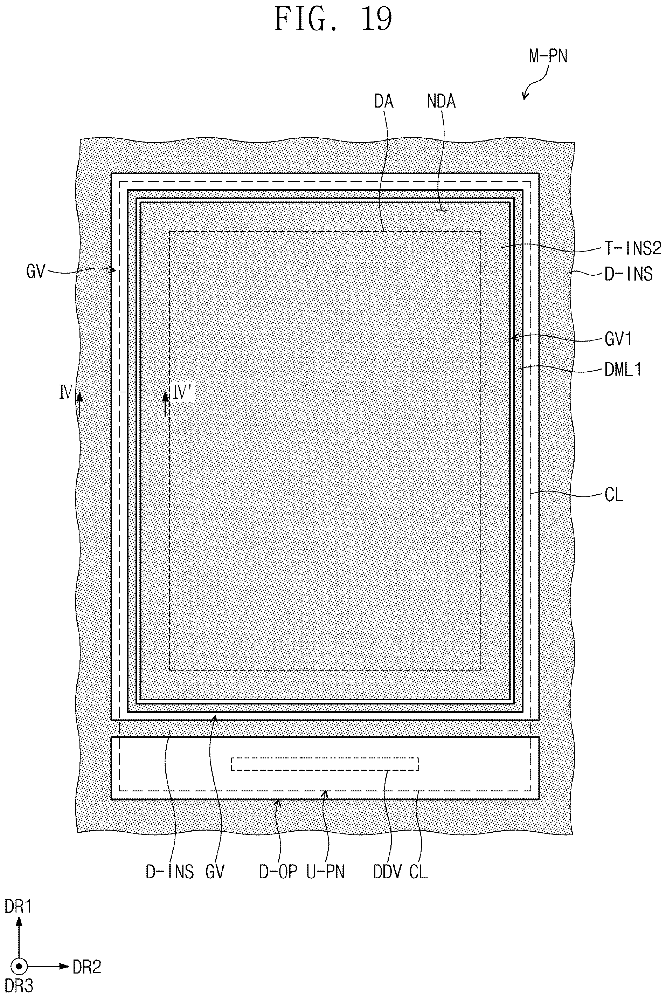

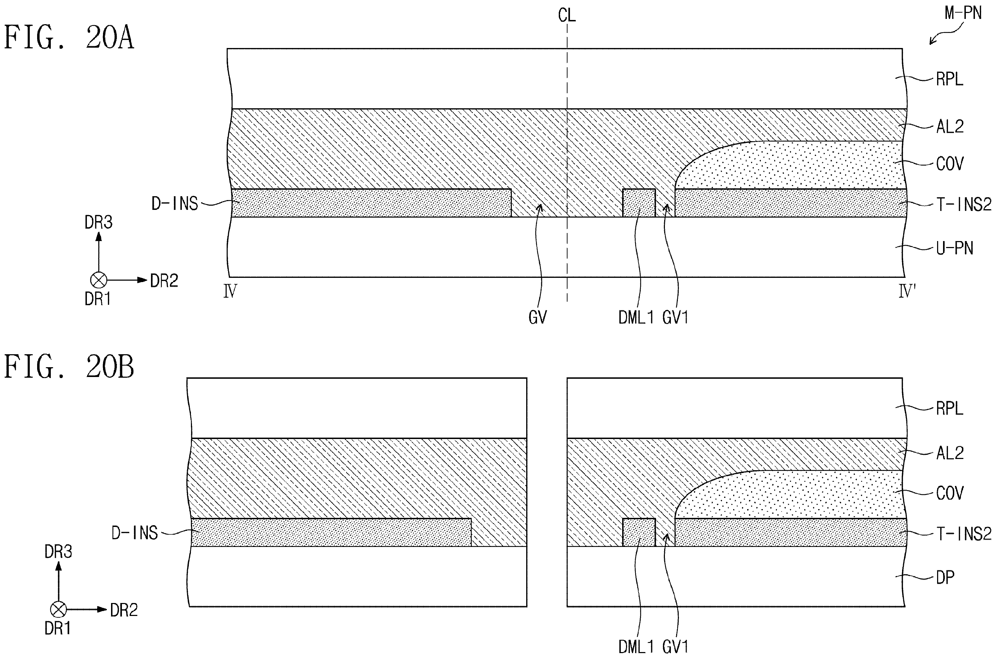

FIG. 19 is a view illustrating a configuration of a unit panel according to one or more other embodiments of the present invention. FIG. 20A is a cross-sectional view taken along the line IV-IV' illustrated in FIG. 19. FIG. 20B is a view illustrating a unit panel that is cut along the cutting line illustrated in FIG. 20A and is separated from the mother panel.

FIG. 19 illustrates a plan view corresponding to FIG. 17. Furthermore, FIGS. 20A and 20B illustrate as cross-sectional views corresponding to FIGS. 18A and 18B, respectively.

Hereinafter, the configurations illustrated in FIGS. 19, 20A, and 20B will be described, focusing on configurations different from those illustrated in FIGS. 17, 18A, and 18B.

Referring to FIG. 19, a first dam layer DML1 may be located on the unit panel DP. When viewed on a plane, the first dam layer DML1 may surround the second insulating layer T-INS2. The first dam layer DML1 may surround the display area DA when viewed on a plane. When viewed on a plane, the dummy insulating layer D-INS may surround the first dam layer DML1.

The groove GV may be defined between the dummy insulating layer D-INS and the first dam layer DML1. The groove GV may surround the first dam layer DML1. A first groove GV1 may be defined between the first dam layer DML1 and the second insulating layer T-INS2.

When the organic ink is provided on the second insulating layer T-INS2, the organic ink may extend to the edge of the second insulating layer T-INS2 depending on a surface tension thereof. When the organic ink is excessively provided on the second insulating layer T-INS2, and when the organic ink overflows the second insulating layer T-INS2, the organic ink that overflows the second insulating layer T-INS2 may be accommodated in the first groove GV1. That is, the first dam layer DML1 may function as a dam.

When the excessive organic ink is more excessively provided on the second insulating layer T-INS2, the organic ink may overflow past the first dam layer DML1. In this case, the organic ink that overflows the first dam layer DML1 may be additionally accommodated in the groove GV.

Referring to FIGS. 20A and 20B, the unit panel U-PN may be separated from the mother panel M-PN to form a display panel DP. A first dam layer DML1 may be located on the display panel DP, and the first dam layer DML1 may be spaced apart from the edge of the display panel DP. The first dam layer DML1 may be located between the edge of the display panel DP and the second insulating layer T-INS2. The first dam layer DML1 and the second insulating layer T-INS2 may be formed concurrently or substantially simultaneously of the same material.

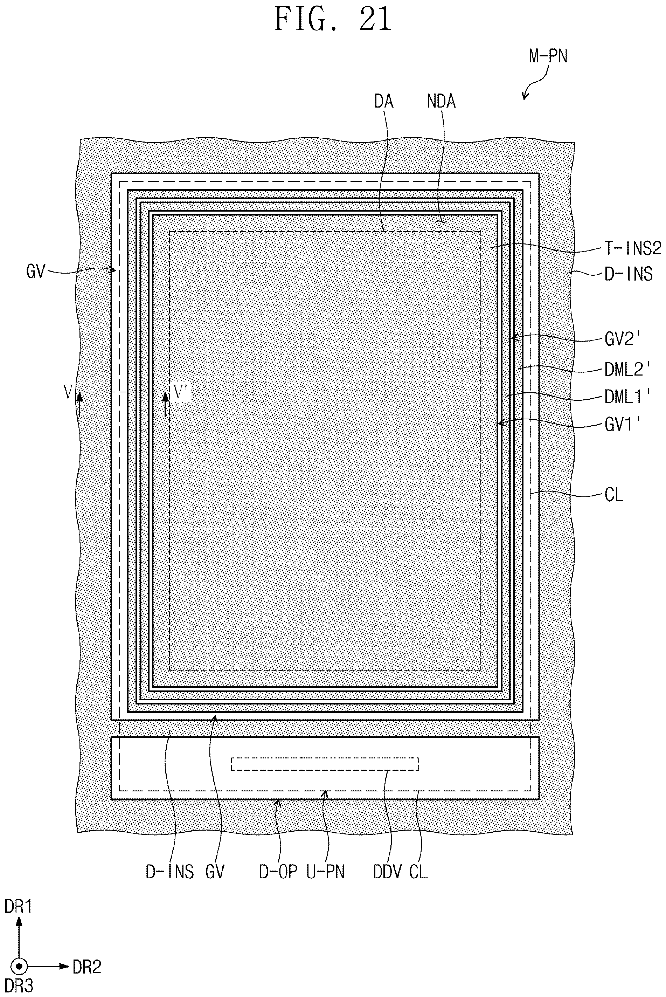

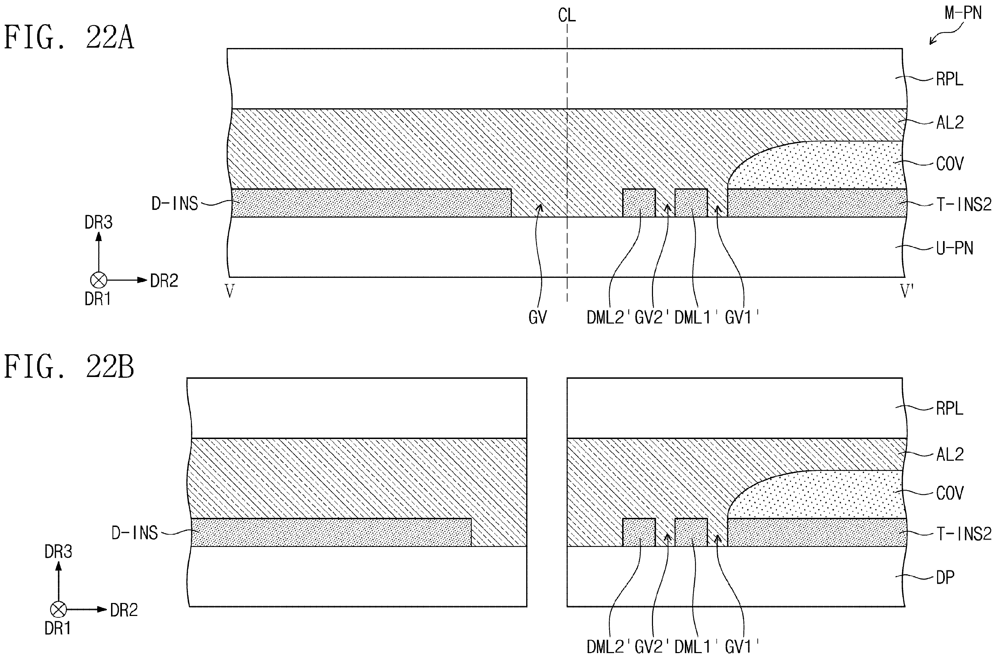

FIG. 21 is a view illustrating a configuration of a unit panel according to one or more other embodiments of the present invention. FIG. 22A is a cross-sectional view taken along the line V-V' illustrated in FIG. 21. FIG. 22B is a view illustrating a unit panel that is cut along the cutting line illustrated in FIG. 22A and is separated from the mother panel.

FIG. 21 illustrates a plan view corresponding to FIG. 17. Furthermore, FIGS. 22A and 22B illustrate as cross-sectional views corresponding to FIGS. 18A and 18B, respectively.

Hereinafter, the configurations illustrated in FIGS. 21, 22A, and 22B will be described, focusing on configurations different from those illustrated in FIGS. 17, 18A, and 18B.

Referring to FIG. 21, a first dam layer DML1' and a second dam layer DML2' may be located on the unit panel DP. When viewed on a plane, the first dam layer DML1' may surround the second insulating layer T-INS2. When viewed on a plane, the second dam layer DML2' may surround the first dam layer DML1'. The first dam layer DML1' and the second dam layer DML2' may surround the display area DA when viewed on a plane. The dummy insulating layer D-INS may surround the second dam layer DML2'.

The groove GV may be defined between the dummy insulating layer D-INS and the second dam layer DML2'. The groove GV may surround the second dam layer DML2'. A first groove GV1' may be defined between the first dam layer DML1' and the second insulating layer T-INS2. A second groove GV2' may be defined between the second dam layer DML2' and the first dam layer DML1'.

When the organic ink is provided on the second insulating layer T-INS2, the organic ink may be located to the edge of the second insulating layer T-INS2 depending on a surface tension thereof. However, when the organic ink is provided excessively, it may overflow past the second insulating layer T-INS2, the first dam layer DML1', or the second dam layer DML2'. In this case, the organic ink may be accommodated in the first groove GV1', the second groove GV2', or the groove GV.

Referring to FIGS. 22A and 22B, the unit panel U-PN may be separated from the mother panel M-PN to form a display panel DP. A first dam layer DML1' and a second dam layer DML2' may be located on the display panel DP, and the first dam layer DML1' and the second dam layer DML2' may be separated from the edge of the display panel DP.

The first dam layer DML1' may be located between the edge of the display panel DP and the second insulating layer T-INS2. The second dam layer DML2' may be located between the edge of the display panel DP and the first dam layer DML 1'. The second insulating layer T-INS2, the first dam layer DML 1', and the second dam layer DML2' may be formed concurrently or substantially simultaneously of the same material.

The widths of the first dam layer DML1' and the second dam layer DML2' may be about 1 micrometer to about 30 micrometers, for example, about 5 micrometers to about 20 micrometers. The widths of the first groove GV1' and the second groove GV2' may be about 1 micrometer to about 20 micrometers, for example, about 5 micrometers to about 15 micrometers. The thicknesses of the first dam layer DML1' and the second dam layer DML2' may be about 0.1 micrometer to about 3 micrometers, for example, about 1.5 micrometers to about 2.5 micrometers.

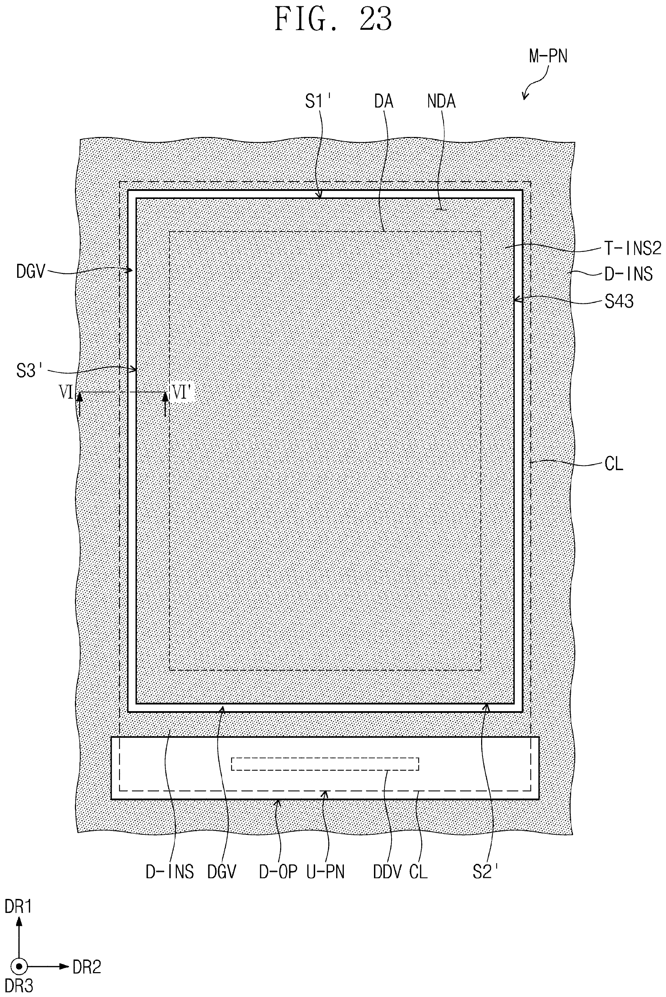

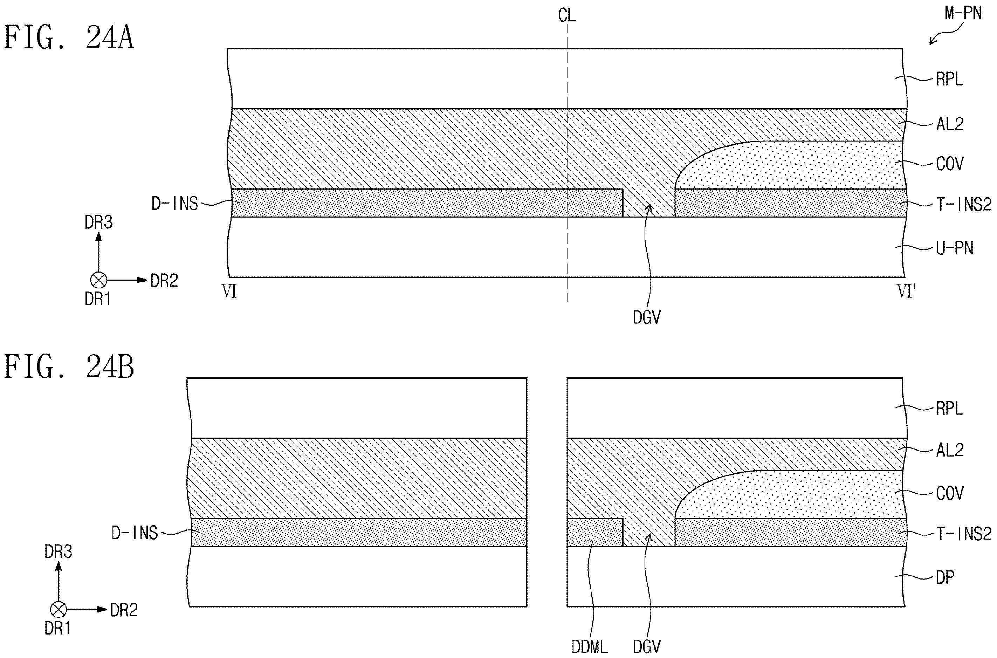

FIG. 23 is a view illustrating a configuration of a unit panel according to one or more other embodiments of the present invention. FIG. 24a is a cross-sectional view taken along the line VI-VI' illustrated in FIG. 23. FIG. 24B is a view illustrating a unit panel that is cut along the cutting line illustrated in FIG. 24A and is separated from the mother panel.

FIG. 23 illustrates a plan view corresponding to FIG. 17. Furthermore, FIGS. 24A and 24B illustrate as cross-sectional views corresponding to FIGS. 18A and 18B, respectively.

Hereinafter, the configurations illustrated in FIGS. 23, 24A, and 24B will be described, focusing on configurations different from those illustrated in FIGS. 17, 18A, and 18B.

Referring to FIG. 23, the dummy insulating layer D-INS may be located to overlap the cutting line CL that is adjacent to the first side S1', the third side S3', and the fourth side S4'. The dummy insulating layer D-INS may surround the second insulating layer T-INS2, and a dummy groove DGV may be defined between the dummy insulating layer D-INS and the second insulating layer T-INS2. The dummy groove DGV may be defined on an inside of the cutting line (e.g., the edge of the unit panel DP).

Referring to FIGS. 24A and 24B, the unit panel U-PN may be separated from the mother panel M-PN to form a display panel DP. The dummy insulating layer D-INS that is located and remains on the display panel DP may be defined as a dummy dam layer DDML. The dummy dam layer DDML may be spaced apart from the second insulating layer T-INS2, and the edge of the dummy dam layer DDML may overlap, or may be aligned with, the edge of the display panel DP. A dummy groove DGV may be defined between the dummy dam layer DDML and the second insulating layer T-INS2.

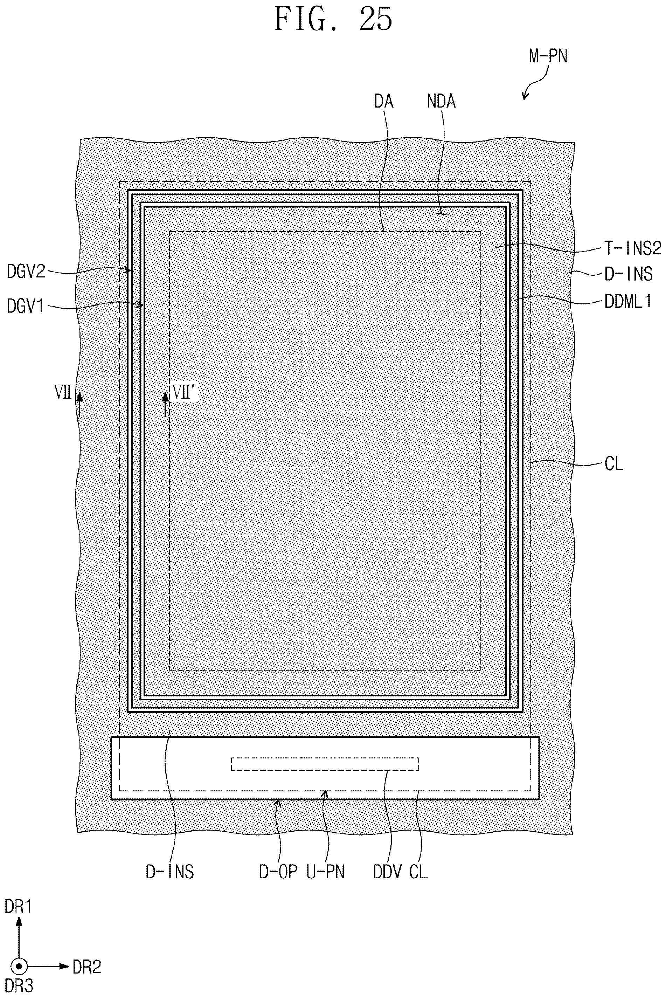

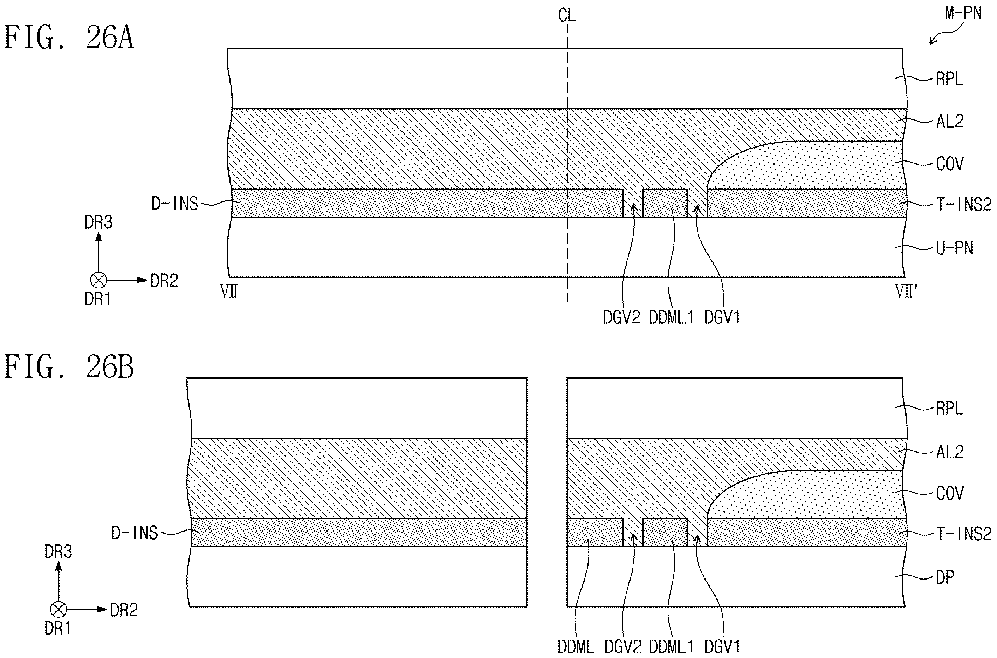

FIG. 25 is a view illustrating a configuration of a unit panel according to one or more other embodiments of the present invention. FIG. 26A is a cross-sectional view taken along the line VII-VII' illustrated in FIG. 25. FIG. 26B is a view illustrating a unit panel that is cut along the cutting line illustrated in FIG. 26A and is separated from the mother panel.

FIG. 25 illustrates a plan view corresponding to FIG. 17. Furthermore, FIGS. 26A and 26B illustrate as cross-sectional views corresponding to FIGS. 18A and 18B, respectively.

Hereinafter, the configurations illustrated in FIGS. 25, 26A, and 26B will be described, focusing on configurations different from those illustrated in FIGS. 17, 18A, and 18B.

Referring to FIG. 25, the dummy insulating layer D-INS may have substantially the same configuration as that of the dummy insulating layer D-INS illustrated in FIG. 23. A first dummy dam layer DDML1, that is an additional dummy dam layer, may be located between the dummy insulating layer D-INS and the second insulating layer T-INS2. The first dummy dam layer DDML1 may be located on the unit panel U-PN. The first dummy dam layer DDML1 may surround the second insulating layer T-INS2, and the dummy insulating layer D-INS may surround the first dummy dam layer DDML1.

A first dummy groove DGV1 may be defined between the first dummy dam layer DDML1 and the second insulating layer T-INS2. A second dummy groove DGV2 may be defined between the dummy insulating layer D-INS and the first dummy dam layer DDML1.

Referring to FIGS. 26A and 26B, the unit panel U-PN may be separated from the mother panel M-PN to form a display panel DP. The dummy dam layer DDML and the first dummy dam layer DDML1 may be located on the display panel DP.

The dummy dam layer DDML may be spaced apart from the second insulating layer T-INS2, and the first dummy dam layer DDML1 may be located between the dummy dam layer DDML and the second insulating layer T-INS2. A first dummy groove DGV1 may be defined between the first dummy dam layer DDML1 and the second insulating layer T-INS2, and a second dummy groove DGV2 may be defined between the dummy dam layer DDML and the first dummy dam layer DDML1.

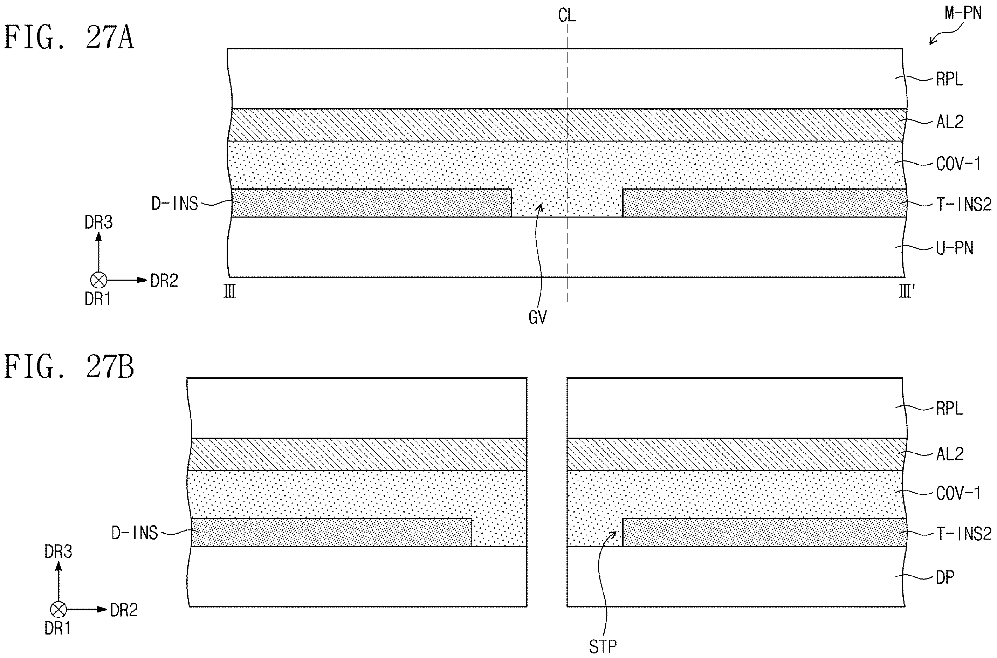

FIGS. 27A, 27B, 28A, 28B, 29A, 29B, 30A, 30B, 31A, and 31B are views illustrating the configurations on the unit panel according to various embodiments of the present invention.

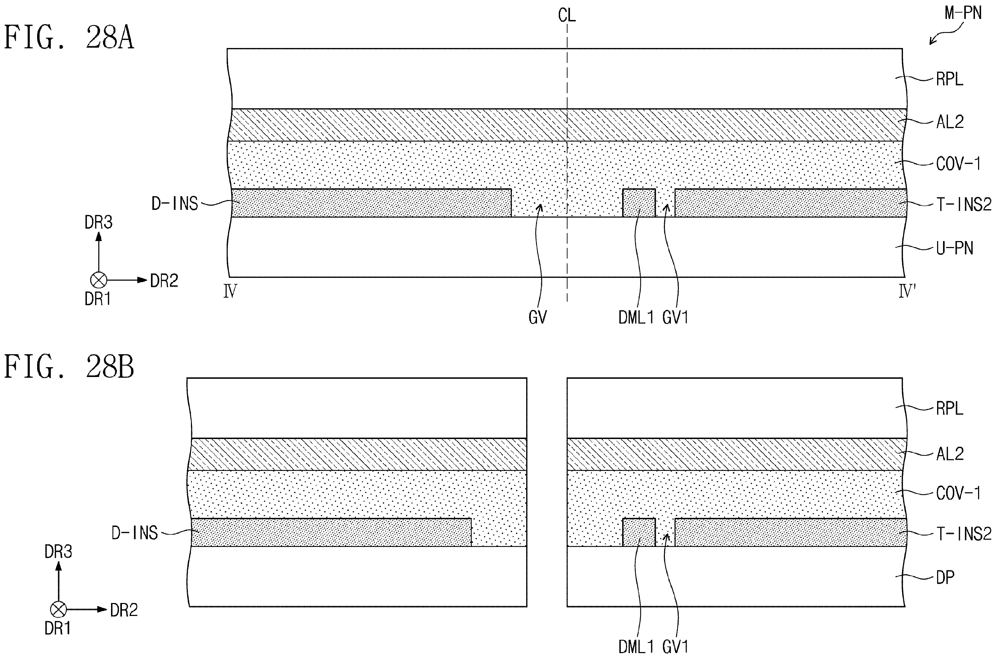

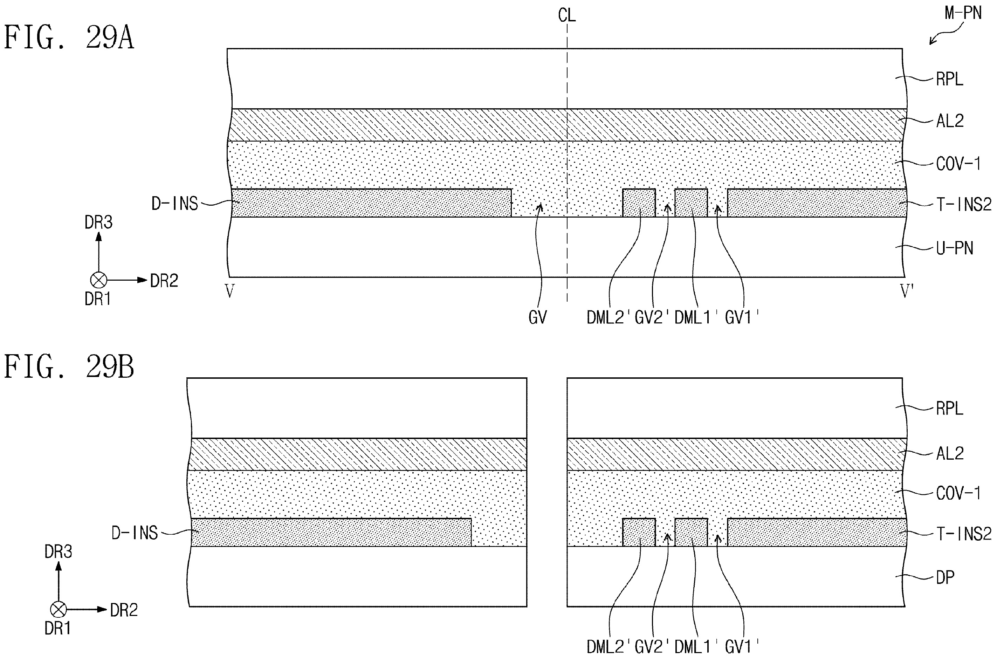

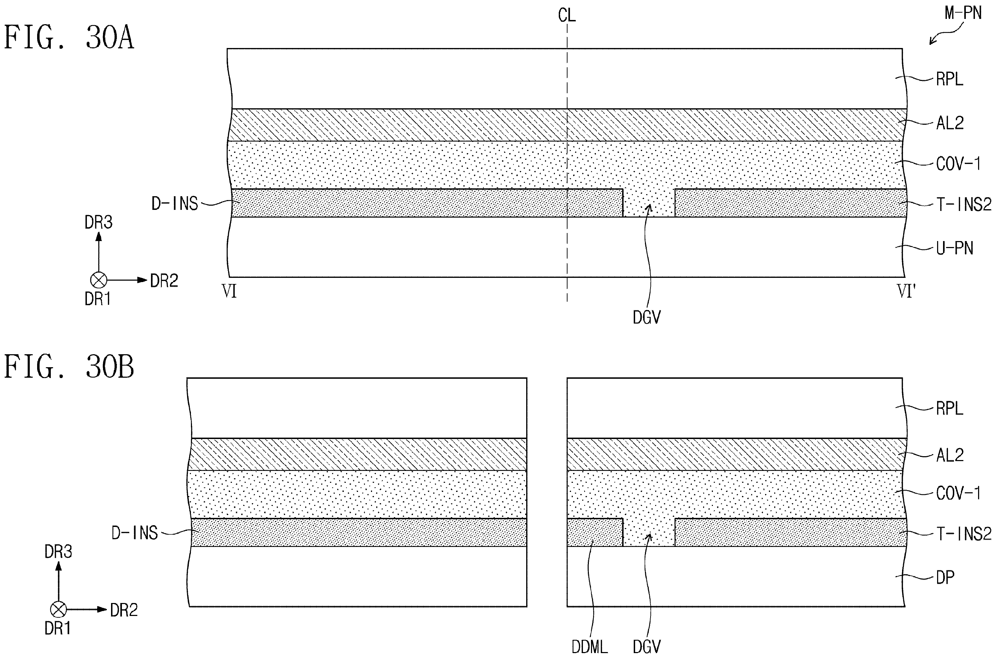

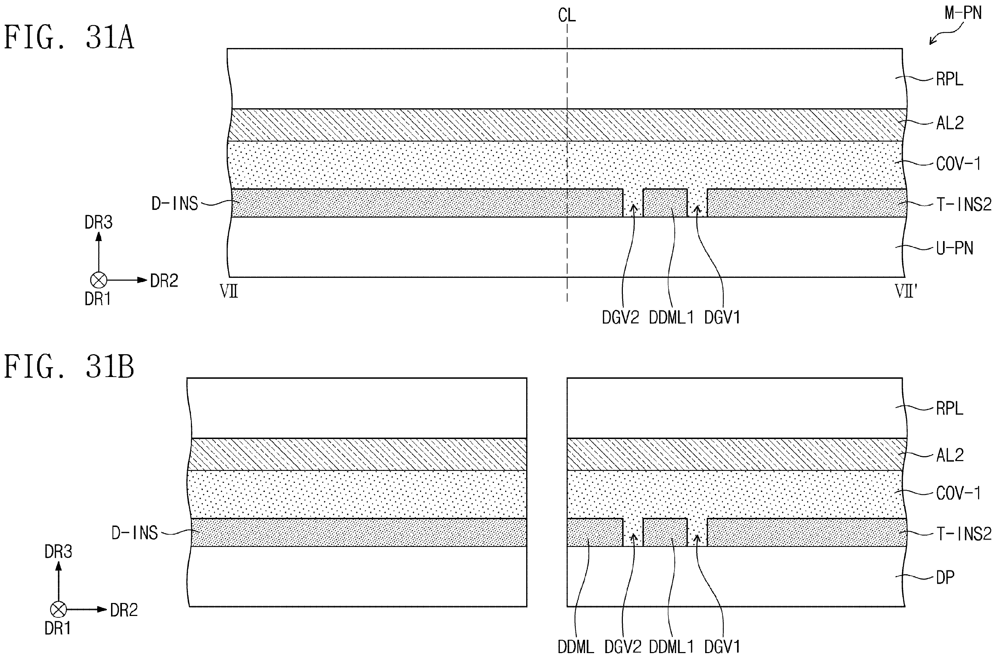

FIGS. 27A and 27B are views illustrating one or more embodiments modified from the one or more embodiments corresponding to FIGS. 18A and 18B. FIGS. 28A and 28B are views illustrating one or more embodiments modified from the one or more embodiments corresponding to FIGS. 20A and 20B. FIGS. 29A and 29B are views illustrating one or more embodiments modified from the one or more embodiments corresponding to FIGS. 22A and 22B. FIGS. 30A and 30B are views illustrating one or more embodiments modified from the one or more embodiments corresponding to FIGS. 24A and 24B. FIGS. 31A and 31B are views illustrating one or more embodiments modified from the one or more embodiments corresponding to FIGS. 26A and 26B.

Hereinafter, focusing on configurations different from those illustrated in FIGS. 18A, 18B, 20A, 20B, 22A, 22B, 24A, 24B, 26A, and 26B, the configurations illustrated in FIGS. FIGS. 27A, 27B, and 28A, 28B, 29A, 29B, 30A, 30B, 31A, and 31B will be described.

Referring to FIGS. 27A and 27B, a cover layer COV-1 may be located on the second insulating layer T-INS2, the dummy insulating layer D-INS, and the display panel DP. The cover layer COV-1 may fill the groove GV. The second adhesion layer AL2 may be located on the cover layer COV-1. The unit panel U-PN may be separated from the mother panel M-PN to form a display panel DP. The configuration illustrated in FIG. 27B may be substantially the same as the configuration illustrated in FIG. 14.

Referring to FIGS. 28A and 28B, the cover layer COV-1 may be located on the second insulating layer T-INS2, the dummy insulating layer D-INS, the first dam layer DML1, and the display panel DP. The cover layer COV-1 may fill the groove GV and the first groove GV1. The second adhesion layer AL2 may be located on the cover layer COV-1. The unit panel U-PN may be separated from the mother panel M-PN to form a display panel DP.

Referring to FIGS. 29A and 29B, the cover layer COV-1 may be located on the second insulating layer T-INS2, the dummy insulating layer D-INS, the first dam layer DML1', the second dam layer DML2', and the display panel DP. The cover layer COV-1 may fill the groove GV, the first groove GV1', and the second groove GV2'. The second adhesion layer AL2 may be located on the cover layer COV-1. The unit panel U-PN may be separated from the mother panel M-PN to form a display panel DP.

Referring to FIGS. 30A and 30B, a cover layer COV-1 may be located on the second insulating layer T-INS2, the dummy insulating layer D-INS, and the display panel DP. The cover layer COV-1 may fill the dummy groove DGV. The unit panel U-PN may be separated from the mother panel M-PN to form a display panel DP. The cover layer COV-1 may be located on the dummy dam layer DDML located on the display panel DP.

Referring to FIGS. 31A and 31B, the cover layer COV-1 may be located on the second insulating layer T-INS2, the dummy insulating layer D-INS, the first dummy dam layer DDML1, and the display panel DP. The cover layer COV-1 may fill the first dummy groove DGV1 and the second dummy groove DGV2. The unit panel U-PN may be separated from the mother panel M-PN to form a display panel DP. The cover layer COV-1 may be located on the dummy dam layer DDML and the first dummy dam layer DDML1 located on the display panel DP.

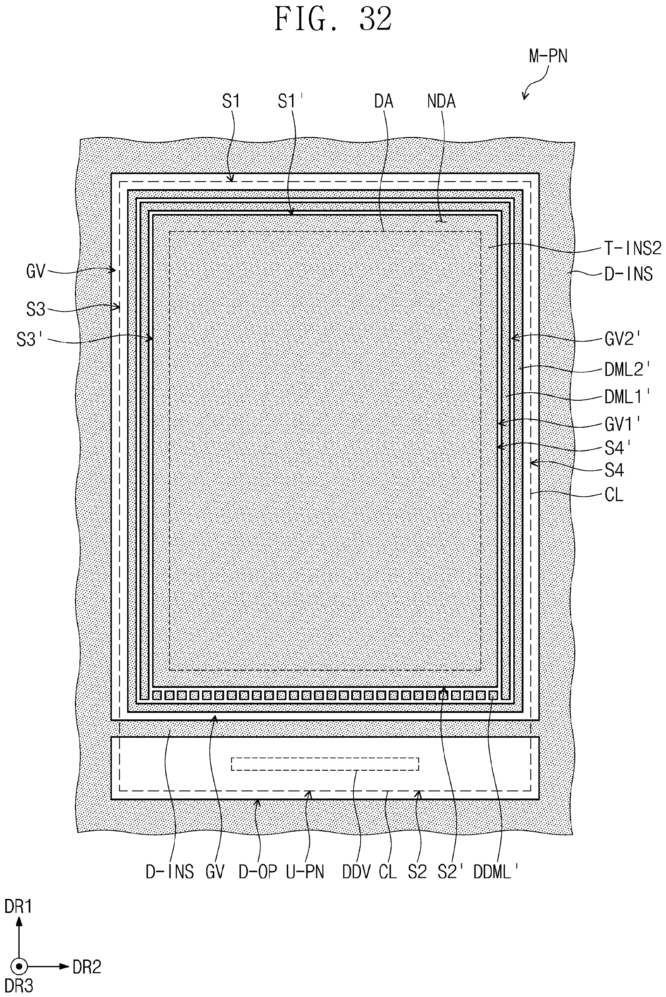

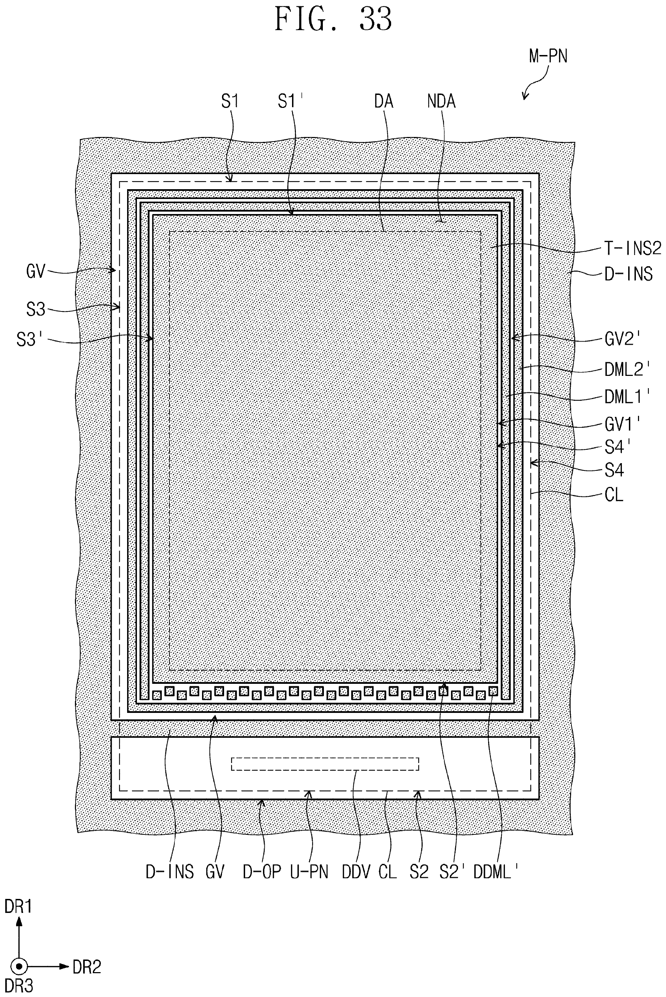

FIGS. 32 and 33 are views illustrating configurations on unit panels according to other embodiments of the present invention.

FIGS. 32 and 33 illustrates a plan view corresponding to FIG. 21.

Hereinafter, the configurations illustrated in FIGS. 32 and 33 will be described, focusing on configurations different from those illustrated in FIG. 21.

Referring to FIGS. 32 and 33, the first dam layer DML1' may be located adjacent to the first side S1', the third side S3', and the fourth side S4'. A plurality of dummy dam layers DDML' may be located between the second side S2 (or a lower side) of the display panel DP and the second insulating layer T-INS2. For example, dummy dam layers DDML' may be located between the second dam layer DML2' and the second side S2' of the second insulating layer T-INS2.

Referring to FIG. 32, the dummy dam layers DDML' may be arranged in the second direction DR2. The second direction DR2 may be defined as a direction that is parallel to the second side S2 of the display panel DP.

Referring to FIG. 33, the dummy dam layers DDML' may be arranged in a zigzag shape along the second direction DR2.

According to the present invention, the side surface of the insulating layer of the input-sensing part and the side surface of the cover layer located on the insulating layer are spaced apart from the edge of the display panel, and the adhesion layer may be located on the cover layer to cover the side surface of the insulating layer and the side surface of the cover layer. As the adhesion layer absorbs an external impact, the external impact applied to the side surface of the insulating layer and the side surface of the cover layer may be reduced.

Because the external impact applied to the side surface of the insulating layer and the side surface of the cover layer is reduced, the side surface of the insulating layer and the side surface of the cover layer may not be delaminated from each other. As a result, damage to a side portion of the display device may be reduced or prevented.

Although the present invention has been described with reference to the embodiments, it will be appreciated by an ordinary skilled in the art, to which the present invention pertains, that the present invention may be modified and changed within the scope of the appended claims. Therefore, the technical scope of the present invention should not be limited to the detailed description of the specification.

## Claims

1. A display device (DD) comprising:
a display panel (DP);
a first conductive pattern (CTL1) above the display panel (DP);
a second conductive pattern (CTL2) above the first conductive pattern (CTL1);
an insulating layer (T-INS2) above the second conductive pattern (CTL2); and
a cover layer (COV) above the insulating layer (T-INS2),
wherein an edge of the insulating layer (T-INS2) and an edge of the cover layer (COV) are aligned and are spaced from an edge of the display panel (DP).

2. The display device (DD) of claim 1, further comprising:
an adhesion layer (AL2) above the cover layer (COV) and the display panel (DP) to cover the edge of the insulating layer (T-INS2) and the edge of the cover layer (COV); and
a reflection reduction layer (RPL) above the adhesion layer (AL2).

3. The display device (DD) of claim 2, wherein the display panel (DP) comprises:
a substrate (SUB); and
a pixel (PX) above the substrate (SUB), and
wherein the adhesion layer (AL2) directly contacts an upper surface of the substrate (SUB) adjacent to an edge of the substrate (SUB).

4. The display device (DD) of at least one of claims 1 to 3, wherein a stepped portion (STP) is defined by upper sides (S1, S1'), left sides (S3, S3'), and right sides (S4, S4') of the display panel (DP) and of the insulating layer (T-INS2).

5. The display device (DD) of at least one of claims 1 to 4, further comprising a dummy insulating layer (D-INS) above the display panel (DP), and between the insulating layer (T-INS2) and the edge of the display panel (DP) in plan view,
wherein a groove (GV) is defined between the dummy insulating layer (D-INS) and the insulating layer (T-INS2).

6. The display device (DD) of claim 5, wherein the dummy insulating layer (D-INS) and the insulating layer (T-INS2) comprise a same material.

7. The display device (DD) of claim 4 and one of claims 5 or 6, wherein the stepped portion (STP) and the groove (GV) have a closed loop and surround a display area (DA) of the display panel (DP) in a plan view.

8. The display device (DD) of at least one of claims 1 to 7, further comprising a first dam layer (DML1) above the display panel (DP), and between the edge of the display panel (DP) and the insulating layer (T-INS2) in a plan view,
wherein a first groove (GV1) is defined between the first dam layer (DML1) and the insulating layer (T-INS2).

9. The display device (DD) of at least one of claims 1 to 7, further comprising:
a first dam layer (DML1') above the display panel (DP), and between the edge of the display panel (DP) and the insulating layer (T-INS2) in a plan view; and
a second dam layer (DML2') above the display panel (DP), and between the edge of the display panel (DP) and the first dam layer (DML1') in a plan view,
wherein a first groove (GV1') is defined between the first dam layer (DML1') and the insulating layer (T-INS2), and
wherein a second groove (GV2') is defined between the second dam layer (DML2') and the first dam layer (DML1').

10. The display device (DD) of claim 9, wherein the insulating layer (T-INS2), the first dam layer (DML1'), and the second dam layer (DML2') comprise a same material.

11. The display device (DD) of claim 9 or 10, wherein the first dam layer (DML1') and the second dam layer (DML2') surround a display area (DA) of the display panel (DP) in a plan view.

12. The display device (DD) of at least one of claims 1 to 4, further comprising a dummy dam layer (DDML) above the display panel (DP), and spaced from the insulating layer (T-INS2),
wherein an edge of the dummy dam layer (DDML) is aligned with the edge of the display panel (DP), and
wherein a dummy groove (DGV) is defined between the dummy dam layer (DDML) and the insulating layer (T-INS2).

13. The display device (DD) of at least one of claims 1 to 4, further comprising:
a dummy dam layer (DDML) above the display panel (DP), and spaced from the insulating layer (T-INS2); and
a first dummy dam layer (DDML1) above the display panel (DP), and between the dummy dam layer (DDML) and the insulating layer (T-INS2),
wherein a first dummy groove (DGV1) is defined between the first dummy dam layer (DDML1) and the insulating layer (T-INS2), and
wherein a second dummy groove (DGV2) is defined between the dummy dam layer (DDML) and the first dummy dam layer (DDML1).

14. The display device (DD) of at least one of claims 1 to 13, further comprising dummy dam layers (DDML') between a lower side (S2, S2') of the display panel (DP) and the insulating layer (T-INS2) in a plan view, especially wherein the dummy dam layers (DDML') are arranged in a direction at least substantially parallel to the lower side (S2) of the display panel (DP) or wherein the dummy dam layers (DDML') are arranged in a zigzag form along a direction substantially parallel to the lower side (S2) of the display panel (DP).
